(19) Europäisches Patentamt
European Patent Office
Office européen des brevets

(11) **EP 4 380 338 A1**

(12) **EUROPEAN PATENT APPLICATION**
published in accordance with Art. 153(4) EPC

(43) Date of publication:
**05.06.2024 Bulletin 2024/23**

(21) Application number: **22849687.3**

(22) Date of filing: **18.05.2022**

(51) International Patent Classification (IPC):
***H10K 50/00*** *(2023.01)* ***H10K 99/00*** *(2023.01)*
***C09K 11/06*** *(2006.01)*

(52) Cooperative Patent Classification (CPC):
**C09K 11/06**

(86) International application number:
**PCT/KR2022/007113**

(87) International publication number:
**WO 2023/008708 (02.02.2023 Gazette 2023/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.07.2021 KR 20210098290**
**27.01.2022 KR 20220012399**

(71) Applicant: **Lordin Co., Ltd**
**Hwaseong-si, Gyeonggi-do 18469 (KR)**

(72) Inventors:
- **KIM, Youngjoon**
**Hwaseong-si, Gyeonggi-do 18469 (KR)**
- **LEE, Hakhoon**
**Hwaseong-si, Gyeonggi-do 18466 (KR)**
- **MUN, Minsik**
**Hwaseong-si, Gyeonggi-do 18466 (KR)**

(74) Representative: **Pfenning, Meinig & Partner mbB**
**Patent- und Rechtsanwälte**
**Theresienhöhe 11a**
**80339 München (DE)**

# (54) ORGANIC LIGHT-EMITTING DIODE

(57) The present disclosure relates an organic light emitting diode including an emission layer including a multifunctional compound.

[Fig. 2]

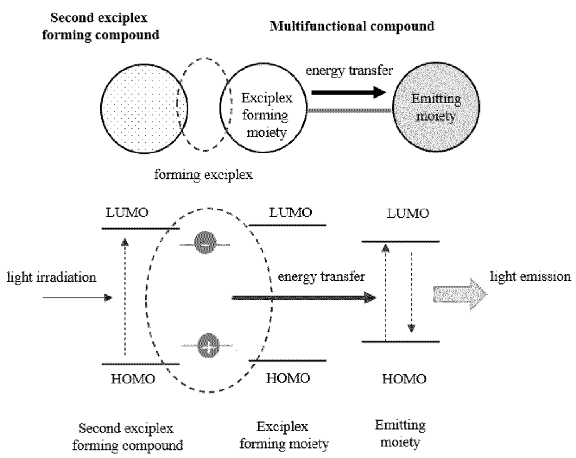


EP 4 380 338 A1

## Description

[Technical Field]

The present disclosure relates to an organic light emitting diode.

[Background Art]

Organic Light Emitting Diode (OLED) is a device that emits light by forming excitons by combining holes injected from the anode and electrons injected from the cathode in the emission layer, which is first reported in Appl. Phys. Lett 51, 913 by C. W. Tang. There are two electrons with different spins in the HOMO wave function of a host in the emission layer. In OLED, as a phenomenon in which electrons go out and enter directly from organic materials, electrons go out from the HOMO (Highest Occupied Molecular Orbital) level and electrons are injected into the LUMO (Lowest Unoccupied Molecular Orbital) level. At this time, since the spin direction of the electron going out or coming in is not fixed, the exciton formed is a triplet with the same spin direction or a singlet with a different spin direction. In organic materials, due to the exchange energy and the repulsive energy between electrons, the triplet usually has smaller energy by 0.5 eV to 1 eV. The ratios of singlets and triplets are theoretically 25% and 75%, and singlets are radiated as light whereas triplets are lost as heat. In order to increase internal quantum efficiency of OLED devices, triplets should be induced to emit light. In a patent filed in 1997 (US6303238B1), Mark E. Thompson reported a technique for a triplet to emit light by increasing spin-orbit coupling using a heavy metal such as Pt. In Nature, 2012, 492, 234-238, Chihaya Adachi designed the molecule so that the wave function overlap between HOMO and LUMO within one molecule should be minimized. In this case, efficiency is increased by thermally activated delayed fluorescence (TADF) where the energy of the triplet is transferred to the singlet and the light emission occurs. However, in the method using heavy metals, Pt, Ir, etc. are very expensive, and blue color should be expressed in triplet, thus the singlet HOMO-LUMO gap energy is high, which may cause a problem in stability of a material. In the method of using TADF, the full width at half maximum (FWHM) of the emission spectrum is widened due to the small degree of overlap of the wave functions of HOMO and LUMO, making it difficult to realize deep blue color, and also has a problem in stability of a material.

Another method studied to reduce the energy difference between a singlet and a triplet is to form an exciplex between a relatively electron-rich electron donor molecule and a relatively electron-poor electron acceptor molecule. The electron donor (or electron acceptor) molecule, once absorbing light and entering an excited state, does Coulombic interaction with the electron acceptor (or electron donor) molecule in the ground state so that the two materials form an exciplex (Valeur, B, Berberan-santos, M.N, Wiley-VCH Verlag GmbH & co. KGaA, 2nd edition, 2012). In this state, the difference between the triplet energy and the singlet energy is small, so that light emission efficiency can be increased. However, even in the case of forming such an exciplex, there is a problem in that it is difficult to realize a deep blue color because it has a very wide FWHM of the emission spectrum, and when doping a dopant to obtain a deep blue color, high quantum efficiency is not able to be acquired because energy transfer from the exciplex to the dopant is not efficient.

[Disclosure]

[Technical Problem]

An object of the present disclosure is to provide an organic light emitting diode with improved quantum efficiency as energy is efficiently transferred.

The objectives of the present disclosure are not limited to the above-mentioned objectives, and other unmentioned obj ectives and advantages of the present disclosure may be understood by the following description, and will be more clearly understood by the embodiments of the present disclosure. In addition, it will be readily apparent that the objectives and advantages of the present disclosure can be realized by means and combinations thereof set forth in the claims.

[Technical Solution]

One of more embodiments include an organic light emitting diode comprising a first electrode, a second electrode and an emission layer interposed between the first electrode and the second electrode,

wherein the organic light emitting diode includes or does not include an organic layer(s) adjacent to one or both surfaces of the emission layer;
the emission layer includes a multifunctional compound;
the emission layer or the organic layer(s) includes an exciplex forming compound;

the multifunctional compound includes an exciplex forming moiety and an emitting moiety;
the exciplex forming moiety forms an exciplex with the exciplex forming compound; and
the emitting moiety emits light by receiving excited energy of the exciplex, which is transferred to the emitting moiety.

[Advantageous Effects]

The organic light emitting diode can realize effective energy transfer between moieties in a multifunctional compound while reducing the energy difference between a singlet and a triplet, and dark blue color easily being able to be implemented, and can obtain high quantum efficiency because energy transfer is efficient.
In addition to the effects described above, specific effects of the present disclosure will be described together while explaining specific details for carrying out the present disclosure.

[Description of Drawings]

Fig. 1 illustrates the mechanism of action of the multifunctional compound by way of example.
Fig. 2 schematically shows the mechanism in which the excited energy of exciplex is transferred between the moieties in the multifunctional compound, resulting in light emission in an organic light emitting diode according to one of embodiments of the present disclosure.
Fig. 3 shows absorption and emission spectra measured for Compounds 1, 2 and 3.
Fig. 4 is an emission spectrum evaluated to determine whether to form an exciplex with compound A.

[Best Mode]

Hereinafter, embodiments of the present disclosure will be described in detail in such a manner that the disclosure may be easily carried out by those skilled in the art to which the present disclosure pertains. The present disclosure may exist as different embodiments and should not be construed as being limited to the ones set forth herein.
The organic light emitting diode according to one embodiment of the present disclosure may include a first electrode, a second electrode and an emission layer interposed between the first electrode and the second electrode,

the organic light emitting diode may or may not include an organic layer(s) adjacent to one or both surfaces of the emission layer,
the emission layer may include a multifunctional compound,
the emission layer or the organic layer(s) may include an exciplex forming compound,
the multifunctional compound may include an exciplex forming moiety and an emitting moiety,
the exciplex forming moiety may form an exciplex with the exciplex forming compound, and
the emitting moiety may emit light by receiving excited energy of the exciplex, which is transferred to the emitting moiety.

The organic light emitting diode improves light emitting efficiency by using the multifunctional compound capable of increasing a rate constant value related to an energy transfer rate.
The organic light emitting diode exhibits high quantum efficiency while realizing a deep blue color.
The exciplex forming moiety is derived from a compound capable of forming an exciplex with the exciplex forming compound.
The multifunctional compound is formed by combining a compound capable of forming an exciplex with the exciplex-forming compound and an emitting compound. Accordingly, the exciplex forming moiety is derived from the compound capable of forming an exciplex with the exciplex forming compound. In addition, the emitting moiety is derived to the emitting compound.
The multifunctional compound includes an exciplex forming moiety resulting from an exciplex forming compound and an emitting moiety resulting from an emitting compound.
The mechanism of an exciplex is a phenomenon that occurs between two molecules. First, one molecule absorbs light corresponding to the HOMO-LUMO gap to enter the excited state, and then interacts with the other molecule to form an exciplex. After the exciplex emits light, the two molecules return to their original state.
When the two molecules are the homogeneous molecules, it could be called an excited dimer or an excimer, and when the two molecules are heterogeneous molecules, it could be called an excited complex or an exciplex. In the present specification, the exciplex is exemplarily described when the two molecules are heterogeneous, but may be applied even when they are homogeneous.

In the present specification, for convenience, the two molecules forming the exciplex are respectively referred to as the first exciplex forming compound and the second exciplex forming compound, respectively. For convenience of distinction, a compound capable of forming an exciplex with the aforementioned exciplex forming compound is referred to as the first exciplex forming compound, and the aforementioned exciplex forming compound is referred to as the second exciplex-forming compound. Accordingly, the exciplex forming moiety is derived from the first exciplex forming compound, the organic layer may comprise the second exciplex forming compound, and the first exciplex forming compound and the second exciplex forming compound together are capable of forming an exciplex.

Each of the first exciplex forming compound and the second exciplex forming compound may be any one molecule capable of forming an exciplex. As described above, in the present specification, "first" and "second" of the first exciplex forming compound and the second exciplex forming compound are named for convenience of distinction, and, for example, the first exciplex forming compound and the second exciplex forming compound may be interchanged with each other.

The first exciplex forming compound and the second exciplex forming compound may be the same or different.

In an organic light emitting diode device, when a material with the low ionization energy and a material with high electron affinity are used together in the emission layer, an exciplex is formed while the electrons are moving. When the emitting compounds, as dopants, are mixed with the exciplexes, the dopants absorb the exciton energy of the exciplexes to cause light emission. In order to cause such light emission, energy transfer efficiency from the exciplexes to the dopants should be high. Energy transfer methods include a method by light in Equation 1 below (FRET, Förster Resonance Energy transfer) and a method by electrons in Equation 2 below (Dexter Electron Transfer).

FRET (Förster Resonance Energy transfer)

[Equation 1]

$$k_{ET} = \left(\frac{1}{r^6\tau_D}\right)\left(\frac{2.07\kappa^2 Q_D J}{128\pi^5 N_A n^4}\right)$$

Dexter Electron Transfer

[Equation 2]

$$k_{ET} \propto J exp^{\left(-\frac{2r}{L}\right)}$$

$k_{ET}$ : rate constant

r : distance between an energy donor and an energy acceptor

$\tau_D$ : PL decay time of an energy donor

$\kappa$ : orientation factor

$Q_D$ : PL quantum efficiency of an energy donor

$N_A$ : Avogadro's number

n : refractive index

J : defined as Equation 3 as below.

[Equation 3]

$$J = \int f_D(\lambda)\varepsilon_A(\lambda)\,\lambda^4 d\lambda$$

$f_D$ : emission spectrum of an energy donor

$\varepsilon_A$ : extinction coefficient according to the wavelength of an energy donor

L : the sum of Van der Waals radii

$\lambda$ : wavelength

The present inventors elaborated the multifunctional compound as a novel compound that allows r in Equations 1 and 2 above to approach 0. The present inventors speculate the advantages when r approaches 0 as follows.

Whether the energy transfer method is the method for light following Equation 1 or the method for electrons following Equation 2, it is the distance (r) between the energy donor (the exciplex) and the energy acceptor (the dopant) that is meaningful. In Equation 1 of energy transfer by light, when the distance (r) approaches 0, quantum (excited complex) efficiency and the decay time of the energy donor become insignificant, and the theoretical energy transfer rate approaches infinity. On the other hand, in Equation 2 of the energy transfer method by electron transfer, when the distance (r) between the two materials approaches 0, the energy transfer rate is only affected by the degree of overlap (J) between the emission spectra and absorption spectra between the two materials.

The multifunctional compound is formed as one molecule of a compound in which one of two molecules forming an exciplex (corresponding to the first exciplex forming compound in the present disclosure) and a dopant (corresponding to the emitting compound in the present disclosure) are combined. With the concepts of Equations 1 and 2 being applied to the multifunctional compound, when the dopant is combined with any one of the two molecules forming the exciplex, the distance is fixed and minimized so that the exciton energy generated at the exciplex can be transferred to the dopant at high speed, causing it to emit light.

That is, the multifunctional compound is a compound obtained by combining the first exciplex forming compound, which is any one of two molecules capable of forming an exciplex, with an emitting compound. Accordingly, the multifunctional compound includes an exciplex forming moiety derived from (or resulting from) the first exciplex forming compound and also includes an emitting moiety derived from (or resulting from) the emitting compound. Since the exciplex forming moiety is derived from (or results from) the first exciplex forming compound, it is capable of forming an exciplex with the second exciplex forming compound.

Since the exciplex forming moiety and the (second) exciplex forming compound may be capable of forming an exciplex, the following energy conditions are satisfied:

Condition 1 or Condition 2 below is satisfied, in which the HOMO energy of the exciplex forming moiety is $E(1)_{HOMO}$, the LUMO energy of the exciplex forming moiety is $E(1)_{LUMO}$, the HOMO energy of the (second) exciplex forming compound is $E(2)_{HOMO}$, and the LUMO energy of the (second) exciplex forming compound is E(2)LUMO,

<Condition 1>

$$|E(1)_{HOMO}| \leq |E(2)_{HOMO}|$$

$$|E(1)_{LUMO}| \leq |E(2)_{LUMO}|$$

and

<Condition 2>

$$|E(1)_{HOMO}| \geq |E(2)_{HOMO}|$$

$$|E(1)_{LUMO}| \geq |E(2)_{LUMO}|$$

and

; and Condition 3 or Condition 4 below is satisfied, in which the exciplex emission energy at the maximum emission wavelength is E(ex) when the exciplex forming moiety and the (second) exciplex forming compound form the exciplex.

<Condition 3>

$$|E(1)_{HOMO}| - |E(2)_{LUMO}| \geq E(ex)$$

<Condition 4>

$$|E(2)_{HOMO}| - |E(1)_{LUMO}| \geq E(ex)$$

Since the exciplex can be formed between the first exciplex forming compound and the second exciplex forming compound, $E(1)_{HOMO}$ can be replaced with the HOMO energy of the first exciplex forming compound instead of the exciplex forming moiety, $E(1)_{LUMO}$ can be replaced with the LUMO energy of the first exciplex forming compound, and the same relationship above, i.e., the relationships of Conditions 1 to 4 may be equally applied.

The HOMO energy of a compound or a moiety can be measured with methods such as Cyclic Voltammetry (CV), Ultraviolet Photoelectron Spectroscopy (UPS), AC2, etc. A value measured by UV absorption spectrum or Cyclic Voltammetry (CV) can be applied to obtain the LUMO energy. In addition, quantum efficiency of the materials mentioned in this specification can be obtained by measurements in dissolving the emitting materials in a solution, filming by co-evaporation with a host material, or dissolving the host material and the emitting material in a solution at the same time, followed by spin coating or casting to form a film.

Fig. 1 illustrates the functioning mechanism of the multifunctional compound by way of example.

Fig. 1 shows the multifunctional compound formed by connecting the first exciplex forming compound having the large HOMO-LUMO gap energy and the emitting compound having the relatively small HOMO-LUMO gap energy through a chemical bond. Upon the exciplex forming moiety derived from the first exciplex forming compound in the multifunctional compound being excited, the energy is transferred to the emitting moiety derived from the emitting compound. This can be confirmed by comparing the absorption spectra and emission spectra of Compound 1 as the first exciplex forming compound, Compound 2 as the emitting compound, and Compound 3 as the multifunctional compound in FIG. 3.

Upon fabricating an organic light emitting diode, the phenomenon can be confirmed that the exciplex energy caused from the exciplexes which is formed by the interactions of the exciplex forming moieties and the (second) exciplex-forming compounds is transferred to the emitting moieties. That is to say, when charges are injected into the emission layer of the organic light emitting diode, the exciplex forming moieties inside the multifunctional compounds and the (second) exciplex-forming compounds form exciplexes first, and the energy of the exciplexes is transferred through the exciplex forming moieties into the emitting moieties. When the exciplex energy caused from the exciplex is greater than the energy of the emitting moiety, the exciplex energy is transferred to the emitting moiety.

Fig. 2 schematically shows the mechanism in which the excited energy of exciplex is transferred between the moieties in the multifunctional compound, resulting in light emission in an organic light emitting diode according to one of embodiments of the present disclosure.

The exciplex forming moiety or the (second) exciplex forming compound absorbs energy from the outside to form an exciplex, and the excited energy of the exciplex is transferred to the emitting moiety connected through the chemical bond so that the emitting moiety emits light.

In more detail, when charges are injected into the emission layer comprising the exciplex forming moiety of the multifunctional compound or the (second) exciplex forming compound inside the organic light emitting diode, the exciplex forming moiety of the multifunctional compound and the second exciplex forming compound interact to form an exciplex, and the exciplex energy thus formed is transferred to the emitting moiety that exists very close within one molecule of the multifunctional compound. At this energy transfer between the moieties in the multifunctional compound, since the distance r is close to 0 in Equations 1 and 2 above, the rate constant becomes very large, resulting in high-efficiency and high-speed energy transfer. Since the exciplex energy is transferred to the emitting moiety, and the emitting moiety can emit light with minimal energy loss, the multifunctional compound can eventually realize an effect capable of emitting light with high efficiency using the exciplex energy.

The organic light emitting diode has the advantage of reducing the energy difference between a singlet and a triplet by using the exciplex, and may effectively transfer energy between moieties in the multifunctional compound, and by including the emitting moiety, it is easy to realize deep blue color while obtaining high quantum efficiency since the

energy transfer is efficient. However, the present disclosure is not limited to implementing blue and may be applied to green, red, and near-infrared light emission, all.

The emitting moiety may be derived from an emitting material (referred to herein as an emitting compound) capable of emitting light by the movement of electrons in an organic light emitting diode.

The emitting compound (emitting material) may be a compound that can be commonly used as a dopant in an organic light emitting diode. A dopant capable of implementing a desired color may be selected according to the purpose.

In one embodiment, the emitting moiety may have a conjugated structure having a quantum efficiency of 50% or more in a visible light wavelength range of 400 nm to 700 nm.

In one embodiment, the emitting moiety may have a conjugated structure having a quantum efficiency of 10% or more in the 700 nm to 2200 nm near-infrared wavelength region.

Specific examples of the emitting compound (or emitting material) may be the following compounds, but are not limited thereto.

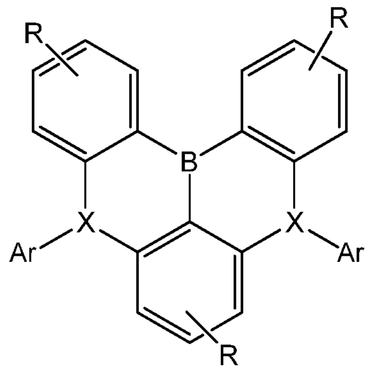

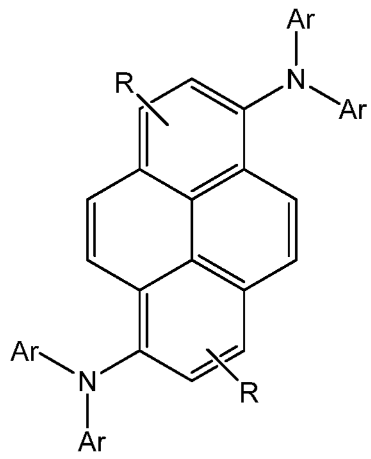

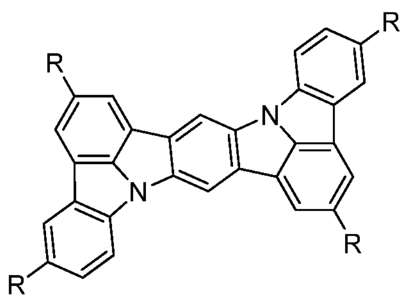

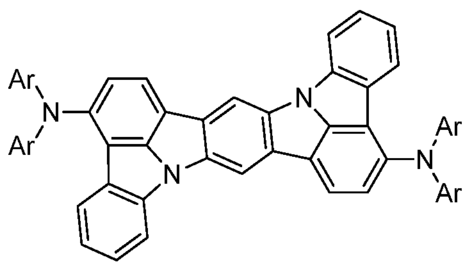

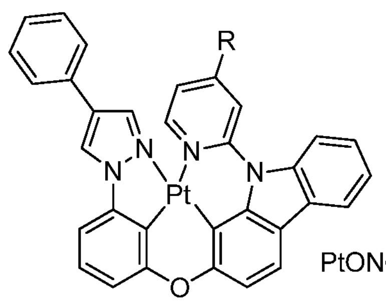

PtON6-tBu

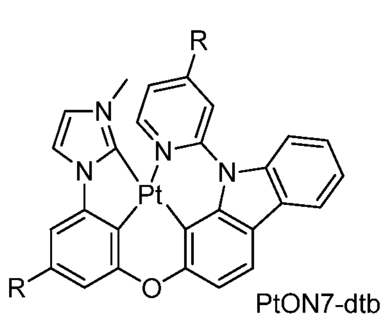

PtON7-dtb

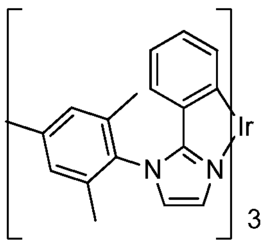

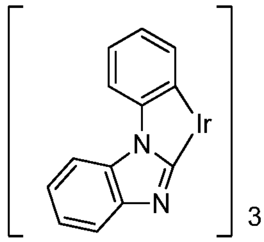

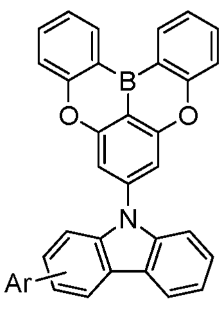

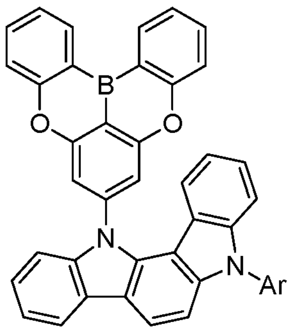

In the above formulae, Ar and R are, respectively, substituted or unsubstituted alkyl having 1 to 20 carbon atoms, substituted or unsubstituted aryl having 6 to 30 carbon atoms, substituted or unsubstituted heteroaryl having 5 to 30 carbon atoms, or substituted or unsubstituted aryl amine having 6 to 30 carbon atoms, and X is an element of nitrogen, oxygen, sulfur, carbon, silicon, Ge or P.

As described above, the emitting compound may be a boron compound in which nitrogen, oxygen, sulfur, carbon, silicon, Ge, P, etc. are substituted, a pyrene compound, a compound having a conjugated structure containing nitrogen, and the like, as such in the above structural formulae, but is not limited thereto.

Further, for the emitting compounds, the materials known as the emitting materials may be used. For example, the light emitting compounds has the conjugated structures such as anthracene, perylene, tetracene, chrysene, coumarine, pyrometane, etc.

In one embodiment, the emitting compound and the emitting moiety may have a conjugated structure including boron.

In one embodiment, the emitting compound and the emitting moiety may contain a metal.

The light emitting mechanism of the emitting moiety may include fluorescence emitting light from a singlet, phosphorescence emitting light from a triplet, and thermally activated delayed fluorescence emitting light when energy is transferred from a triplet to a singlet.

In one embodiment, in the multifunctional compound, the exciplex forming moiety connected by the chemical bond does not change the band gap energy of the emitting moiety by 0.2 eV or more compared to the band gap energy of the emitting compound prior to formation of the chemical bond. Hereby, since the exciplex forming moiety may not significantly affect the emission wavelength of the emitting moiety, it is convenient to apply the known properties of the emitting compound to the emitting moiety for color designing and implementation.

In one embodiment, the second exciplex forming compound may not form an exciplex with the emitting compound. If the emitting compound can form an exciplex with the second exciplex forming compound, the emission wavelength of the emitting moiety may possibly be affected. If the emission wavelength of the emitting moiety changes, it may be difficult to apply the known characteristics of the emitting compound to the emitting moiety for color designing and implementation, or when a predetermined emitting compound is to be used to implement a specific color, it may be difficult to implement a desired color as the emission wavelength of the emitting moiety changes.

In one embodiment, the bandgap energy of the exciplex forming moiety may have the band gap energy 1 eV to 4.7 eV and the emitting moiety may have the band gap energy of 0.5 eV to 3.5 eV.

In one embodiment, the difference in the bandgap energies between the exciplex forming moiety and the emitting moiety may be 2eV or less.

In one embodiment, the difference in the HOMO energy levels of between the exciplex forming moiety and the emitting moiety may be 1.9 eV or less.

In one embodiment, the energy level difference in the LUMO energies between the exciplex-forming moiety and the emitting moiety may be 1.9 eV or less.

In the multifunctional compound, the exciplex forming moiety and the emitting moiety are connected by the

chemical bond. Specifically, the chemical bond may be a single bond, a double bond, a triple bond or a coordinate bond. Specifically, the chemical bond may be a form chemically bonding the exciplex forming moiety and the emitting moiety through a linking group, or connecting the exciplex forming moiety and the emitting moiety in a direct bond without a linking group. Alternatively, the multifunctional compound may be formed by connecting the exciplex forming moiety and the emitting moiety in a spiro structure.

When the first exciplex forming compound and the emitting compound are chemically bonded to form the multifunctional compound, the exciplex forming moiety and the emitting moiety may be derived with the substituents, etc. appropriately modified for chemical bonding. In these cases, the portion modified for chemical bonding may not significantly change the inherent characteristics of each of the first exciplex forming compound and the emitting compound, such as the emission characteristics, the band gap energy, energy efficiency, and so on. For example, the emitting moiety may be formed while a substituent of the emitting compound has been replaced with another one to facilitate a chemical bond, and, however, the replaced substituent may not significantly affect the properties of the emitting moiety such as the emission properties, the band gap energy, energy efficiency, etc.

As used herein, "does not significantly affect" means that it does not deviate the scope of the detailed description for the exciplex forming moiety and emitting moiety in the present specification. Specifically, the fact that a substituent, etc. of the first exciplex forming compound or the emitting compound could be "appropriately" modified while chemically bonding means the conditions maintained to be satisfied such that the exciplex forming moiety of the resulting multifunctional compound forms an exciplex with the exciplex forming compound and that the emitting moiety emits light by receiving the excited energy of the exciplex, which is transferred to the emitting moiety.

In one embodiment, the chemical bond may be connection through a substituted or unsubstituted arylene having 6 to 20 carbon atoms, a carbon atom, an oxygen atom, a nitrogen atom, a silicon atom, a Ge atom, an S atom, or a P atom. For example, the chemical bond may be by a linking group, and the linking group may include a carbon atom, an oxygen atom, a nitrogen atom, a silicon atom, a Ge atom, an S atom, or a P atom. For example, the chemical bond is a form in which the first exciplex forming compound and the emitting compound are directly connected without a linking group, and carbon, oxygen, nitrogen, silicon, Ge, S or P included in the exciplex forming moiety or the emitting moiety could be a connecting position.

In one embodiment, the exciplex forming moiety and the emitting moiety are connected in a spiro structure. The spiro structure may be connection using a medium of carbon, silicon or Ge.

At least one hydrogen atom in the multifunctional compound could be substituted with deuterium.

The multifunctional compound may include a plurality of exciplex forming moieties. In one embodiment, the multifunctional compound may include a first exciplex forming moiety and a second exciplex forming moiety, wherein the detailed descriptions for the first exciplex moiety and the second exciplex moiety are the same as for the above exciplex forming moiety, and they may be the same or different from each other. The second exciplex forming moiety may be linked to the emitting moiety or the first exciplex forming moiety.

As described above, the first exciplex forming compound and the second exciplex forming compound may be the compounds capable of forming an exciplex. An exciplex can be formed between an electron donor molecule with the low ionization energy and an electron acceptor molecule with the high electron affinity.

Accordingly, the first exciplex forming compound and the second exciplex forming compound may be an electron donor molecule or an electron acceptor molecule, provided that when the first exciplex forming compound is an electron donor molecule, the second exciplex forming compound becomes an electron acceptor molecule, and when the first exciplex-forming compound is an electron acceptor molecule, the second exciplex forming compound becomes an electron donor molecule.

For the materials of an electron donor, those containing arylamines in which nitrogen is located mainly outside the aromatic ring may be used.

For example, the materials of an electron donor may be represented by the following chemical formula.

<Formula 1>

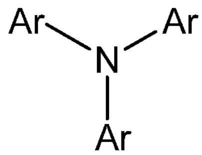

In Formula 1,

Ar may, each independently, be a substituted or unsubstituted aryl having 6 to 30 carbon atoms, a substituted or unsubstituted heteroaryl having 5 to 30 carbon atoms, or a substituted or unsubstituted alkyl having 1 to 20 carbon

atoms, and two of Ar may be connected to form a fused ring having 12 to 30 carbon atoms,
At least one hydrogen atom in Formula 1 is unsubstituted or substituted with deuterium.

The materials of an electron acceptor are mainly the structures in which nitrogen is located in an aromatic ring, such as those containing the following structure may be used.

For example, the material of an electron acceptor may be any one of the structures represented by Formula 2 below.

<Formula 2>

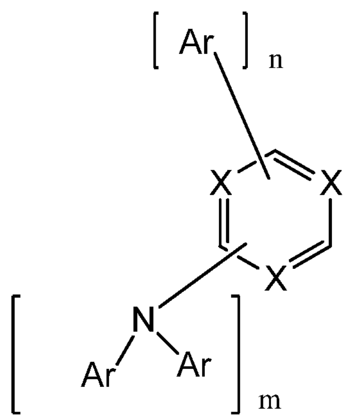

In Formula 2,

X may be nitrogen or carbon;
n and m are integers from 0 to 6, provided that when X is nitrogen, n+m is an integer from 1 to 3, and when X is carbon, n+m is an integer from 1 to 6;
Ar is, each independently, substituted or unsubstituted aryl having 6 to 30 carbon atoms, substituted or unsubstituted heteroaryl having 5 to 30 carbon atoms, substituted or unsubstituted arylsilyl having 6 to 30 carbon atoms, substituted or unsubstituted Aryloxy having 6 to 30 carbon atoms, substituted or unsubstituted alkylsilyl having 1 to 20 carbon atoms, substituted or unsubstituted alkyl having 1 to 20 carbon atoms, substituted or unsubstituted aryl having 6 to 30 carbon atoms and including phosphine or phosphine oxide, and two of Ar may be connected to form a fused ring having 12 to 30 carbon atoms,

At least one hydrogen atom in Formula 2 is unsubstituted or substituted with deuterium.

As used herein, the term "substitution" means that a hydrogen atom bonded to a carbon atom in a compound is substituted with another substituent. The position where substitution occurs means the position where the hydrogen atom is substituted. The position is not limited as long as hydrogen at the position can be substituted with a substituent. When two or more substitutions occur, the two or more substituents may be the same or different.

As used herein, substituents in the case of being "substituted" may be one selected from the group consisting of, for example, hydrogen, deuterium, an alkyl group having 1 to 20 carbon atoms, an alkoxy group having 1 to 20 carbon atoms, a halogen, a cyano group, a carboxy group, a carbonyl group, an amine group, and an alkylamine group having 1 to 20 carbon atoms, a nitro group, an alkylsilyl group having 1 to 20 carbon atoms, an alkoxysilyl group having 1 to 20 carbon atoms, a cycloalkyl silyl group having 3 to 30 carbon atoms, an arylsilyl group having 6 to 30 carbon atoms, an aryl group having 6 to 30 carbon atoms, an arylamine group having 6 to 30 carbon atoms, a heteroaryl group having 5 to 30 carbon atoms, an aryl phosphine oxide group having 6 to 30 carbon atoms, an aryl phosphinyl group having 6 to 30 carbon atoms, an alkyl phosphine oxide group having 6 to 30 carbon atoms, an alkylsulfonyl group having 6 to 30 carbon atoms and their combinations, but is not limited thereto.

Below are the examples of the compounds used as electron donor molecules.

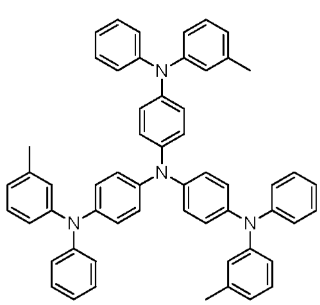

m-MTDTA

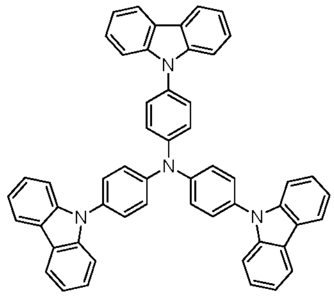

TCTA

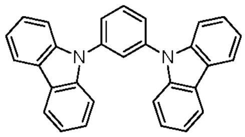

mCP

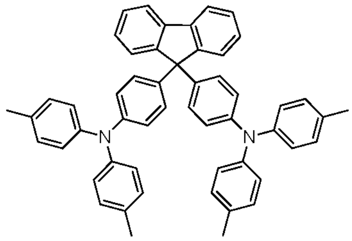

DTAF

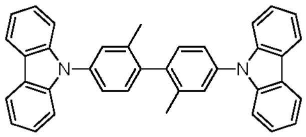

CDBP

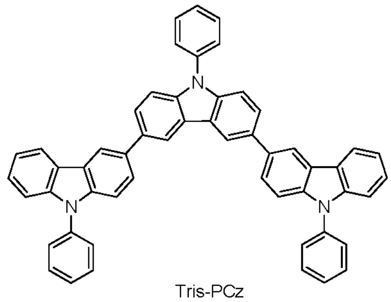

Tris-PCz

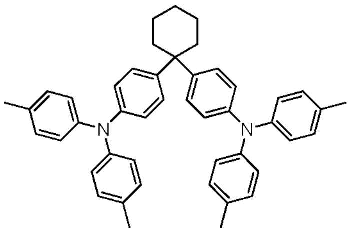

TAPC

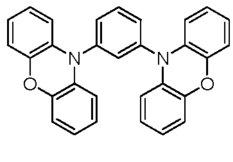

I3PXZB

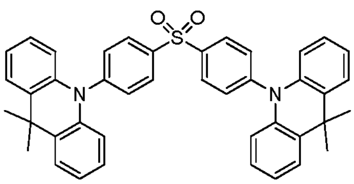

DMAC-DPS

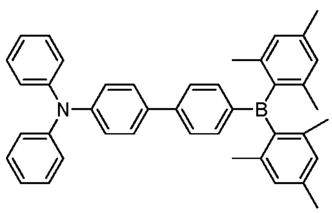

TPAPB

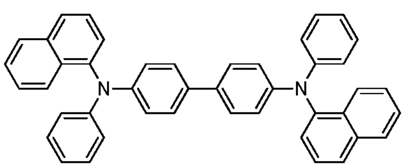

NPB

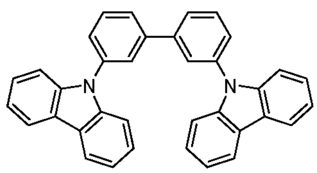

mCBP

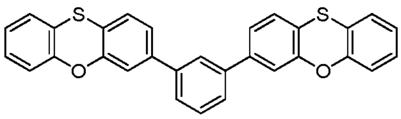

mPXTP

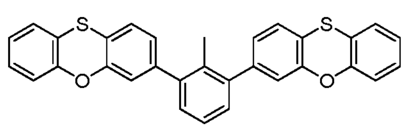

mPXTMP

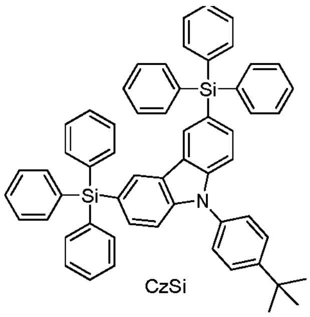

CzSi

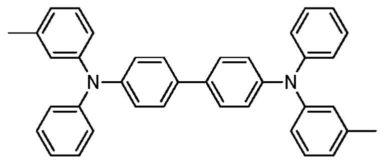

TPD

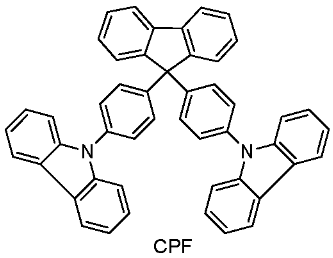

CPF

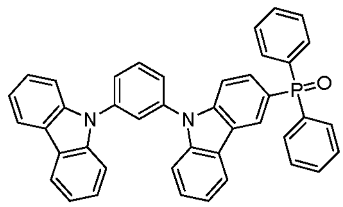

mCPPO1

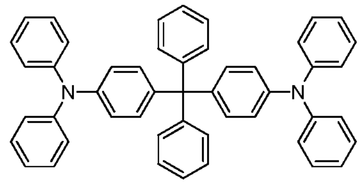

YCBPA

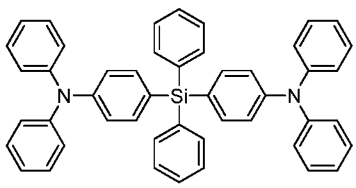

TSBPA

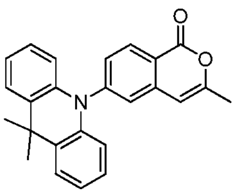

MAC

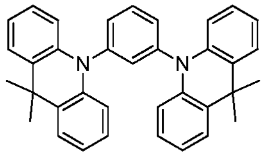

13AB

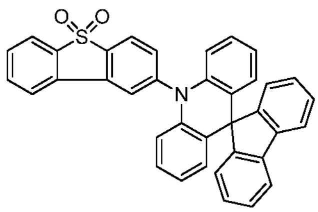

DBT-SADF

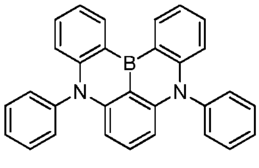

DABNA-1

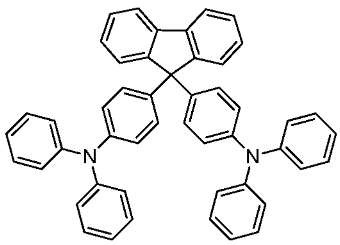

DTF

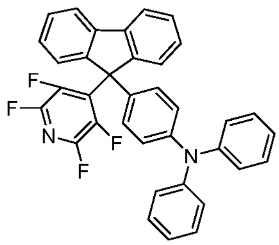

TPA-3

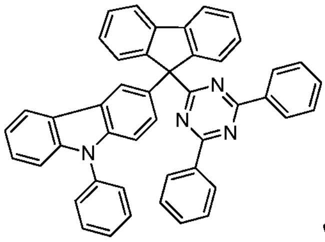

3CzFDPhTz

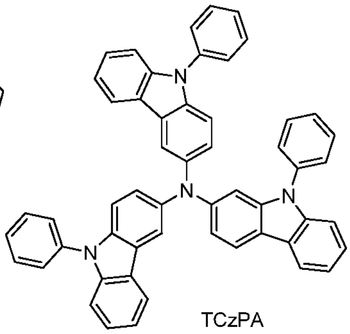

TCzPA

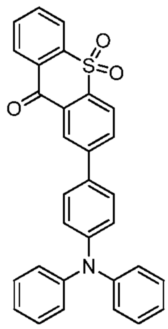

TXO-TPA

Below are the examples of the compounds used as electron acceptor molecules.

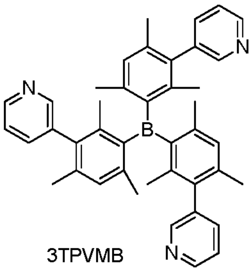

3TPVMB

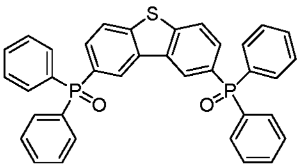

PPT

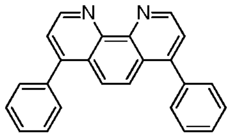

Bphen

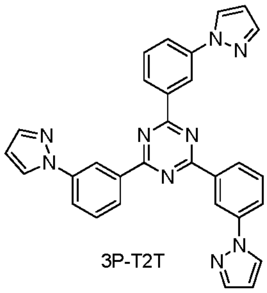

3P-T2T

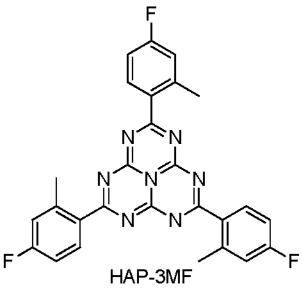

HAP-3MF

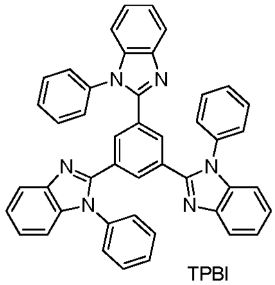

TPBI

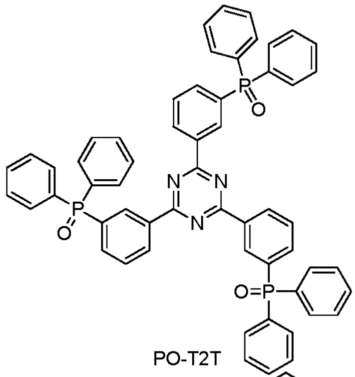

PO-T2T

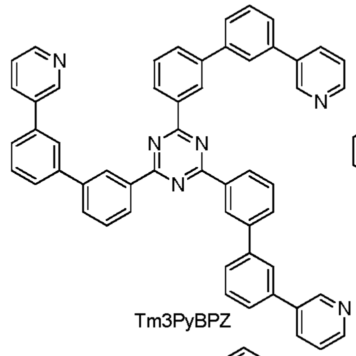

Tm3PyBPZ

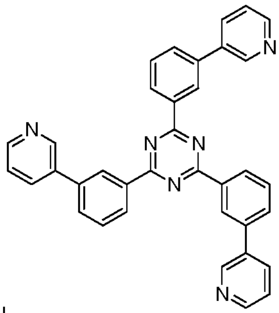

TmPyTZ

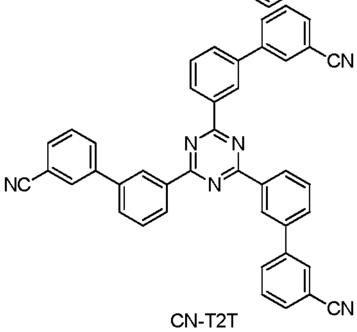

CN-T2T

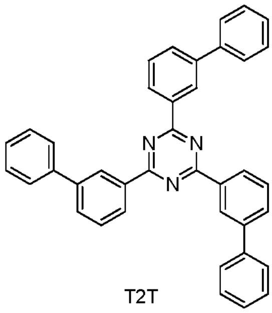

T2T

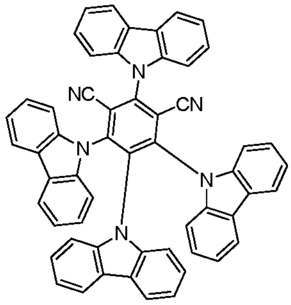

4CzIPN

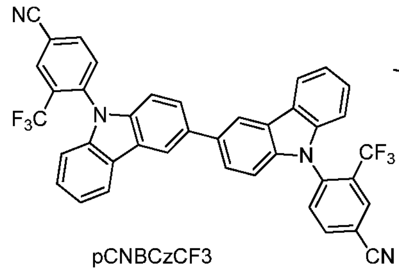

pCNBCzCF3

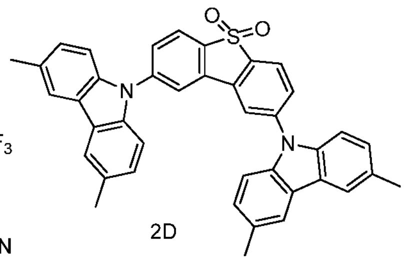

2D

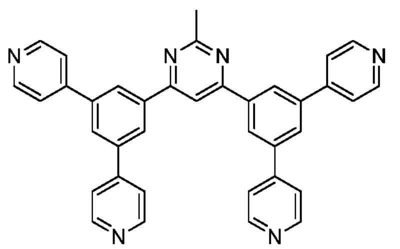

B4PyMPM

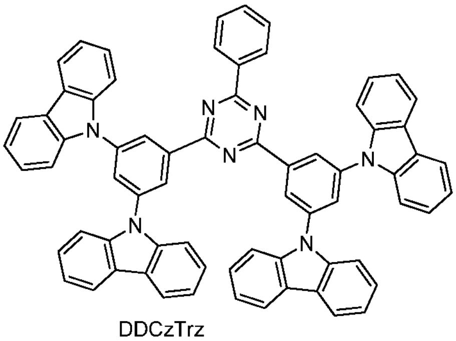

DDCzTrz

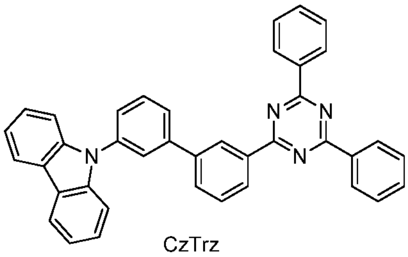

CzTrz

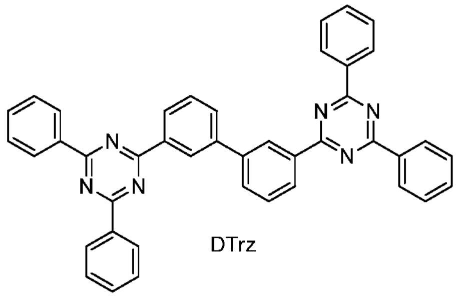

DTrz

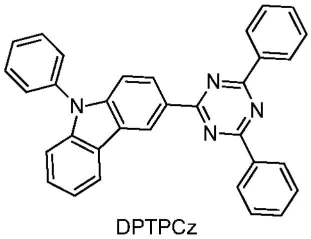

DPTPCz

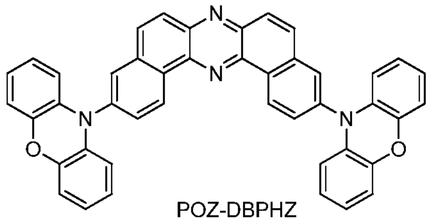

POZ-DBPHZ

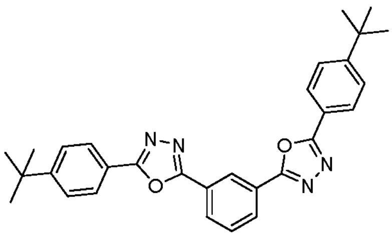

OXD-7

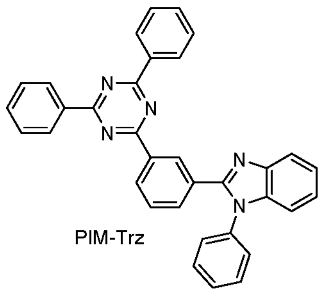

PIM-Trz

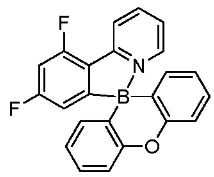

BFPD

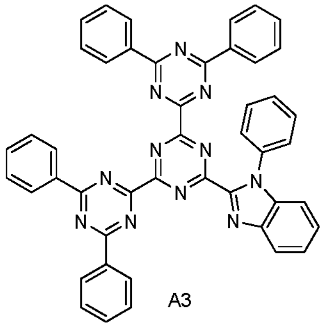

A3

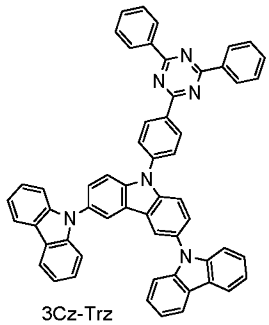

3Cz-Trz

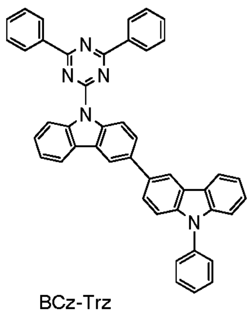

BCz-Trz

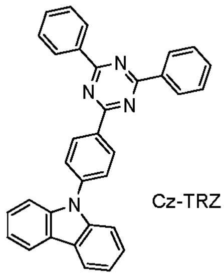

Cz-TRZ

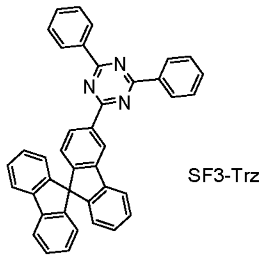

SF3-Trz

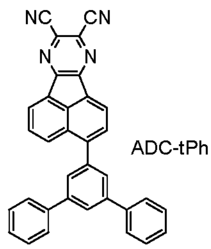

ADC-tPh

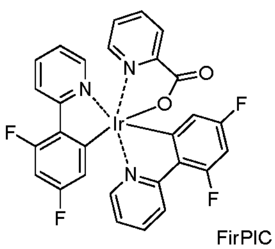

FirPIC

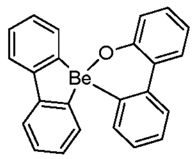

BePP2

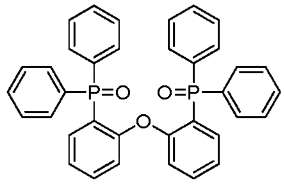

DPEPO

In one embodiment, the first exciplex forming compound may be an organic or organometallic complex, and the exciplex forming moiety may be the derivative thereof.

In one embodiment, the multifunctional compound may be any of the compounds represented by the following structural formulae.

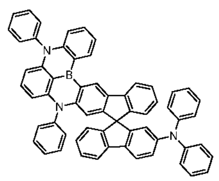
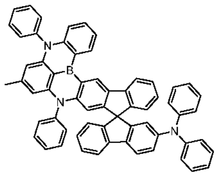
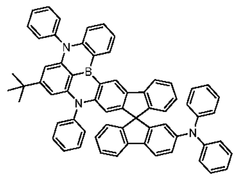
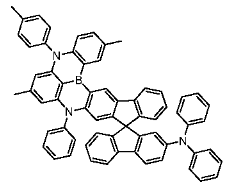
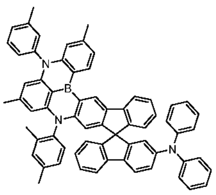
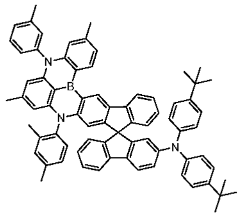
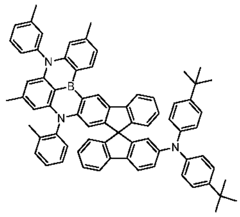
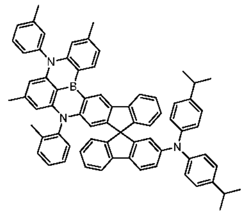
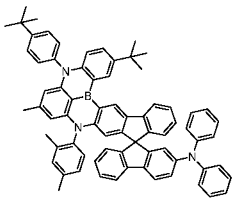
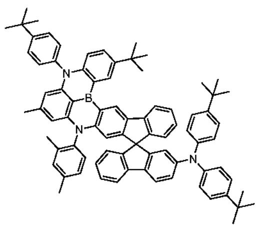
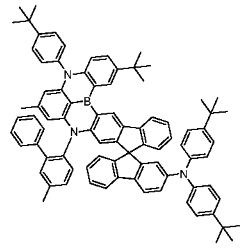
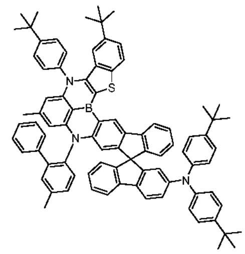
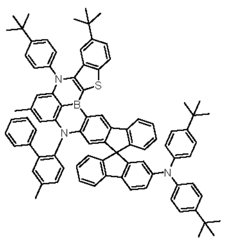
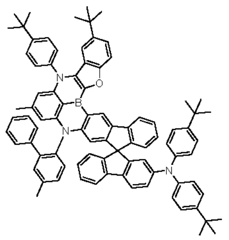
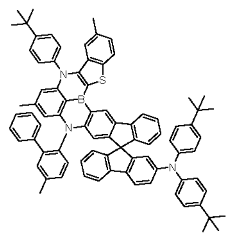
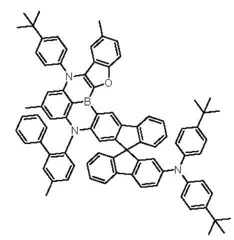
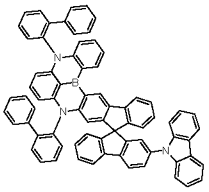
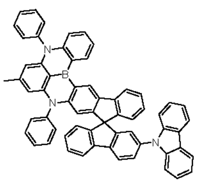
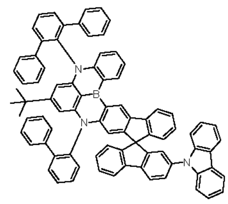
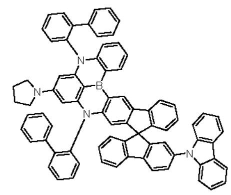
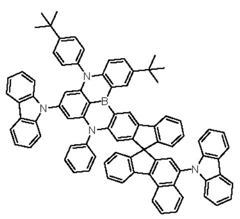
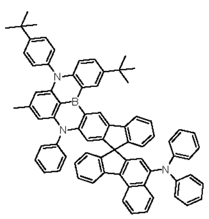
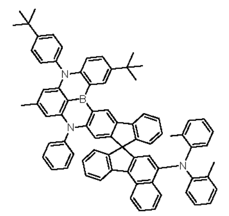
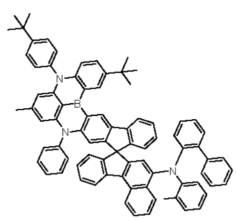

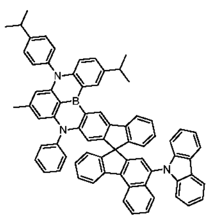
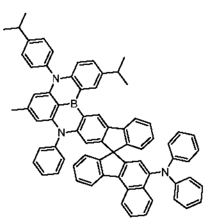
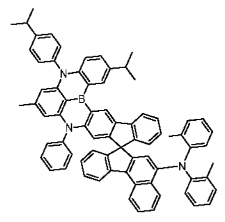
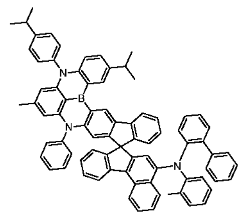
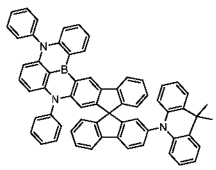
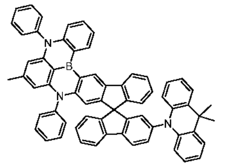
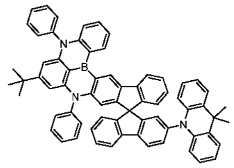
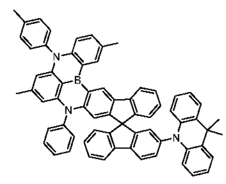
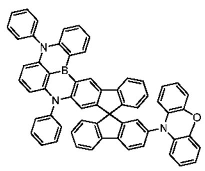
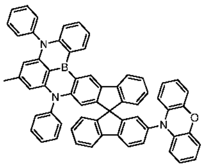
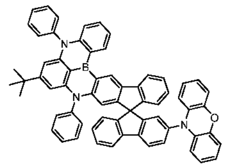
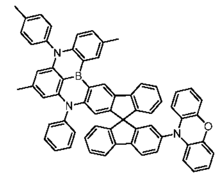
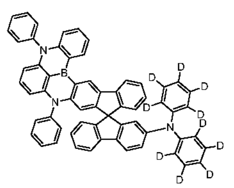
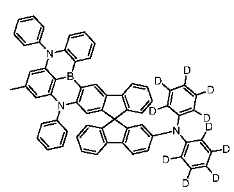
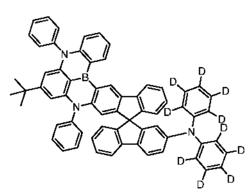
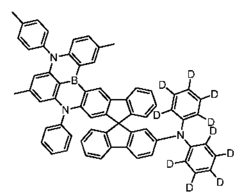
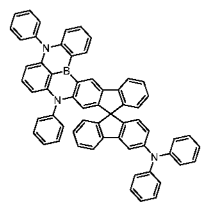
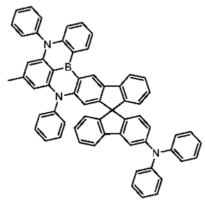
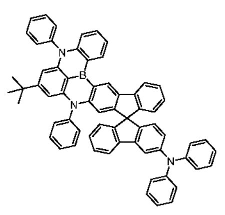
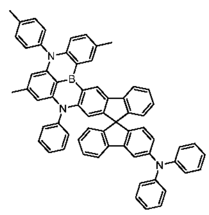
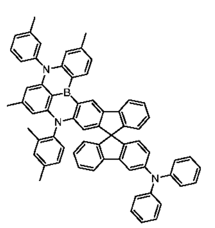
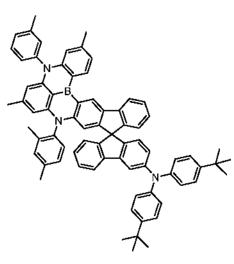
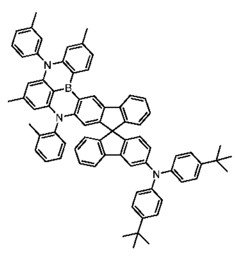
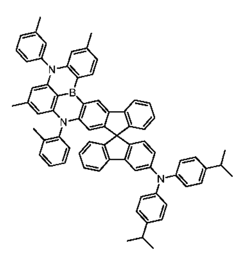
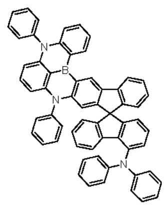
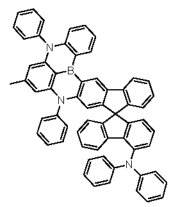
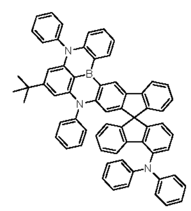
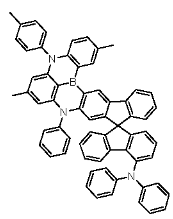

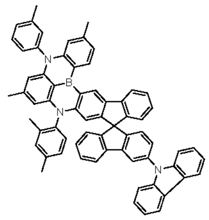
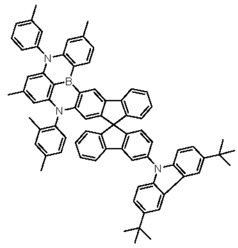
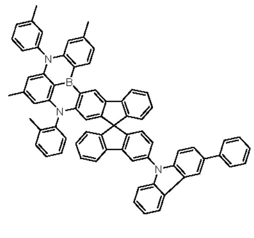
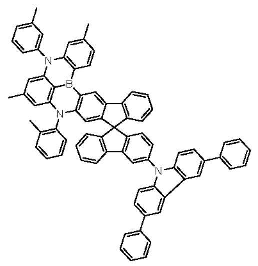

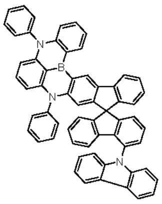
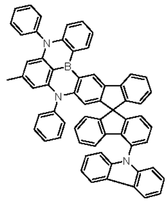
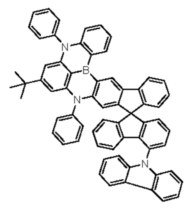
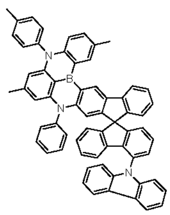

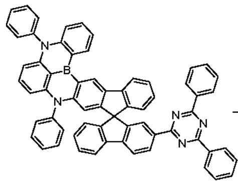
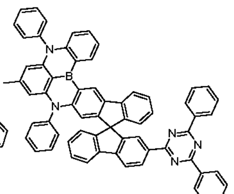
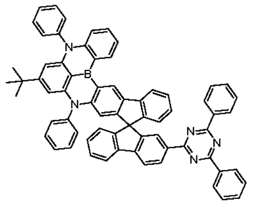
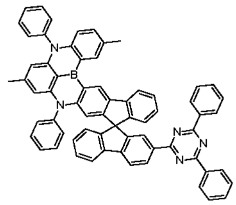

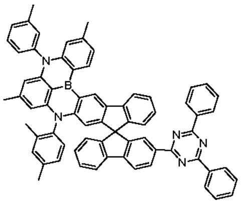
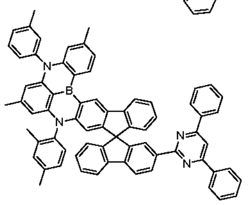
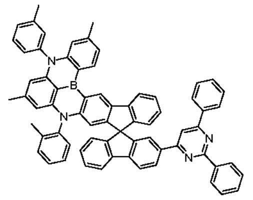
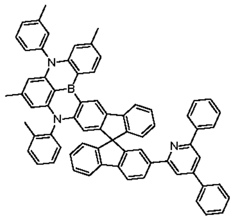

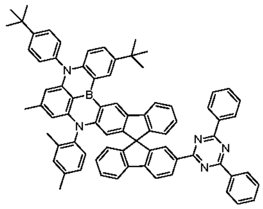
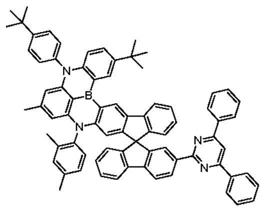
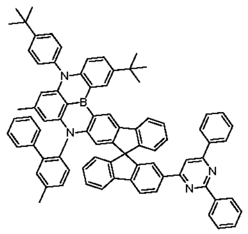
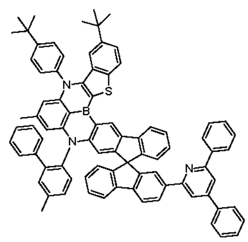

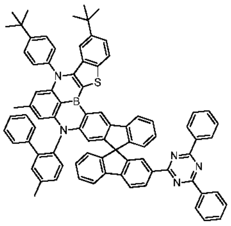
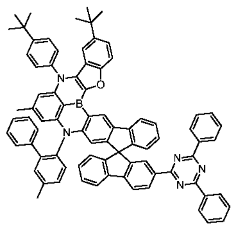
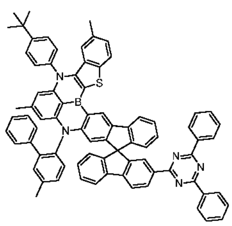
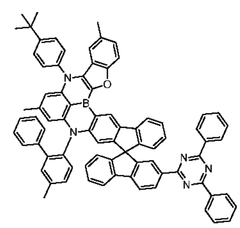

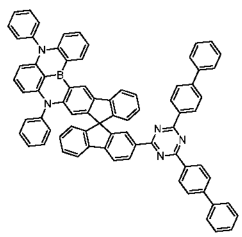 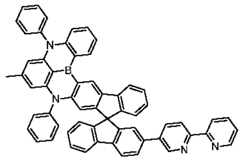 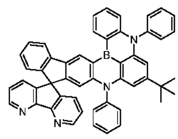 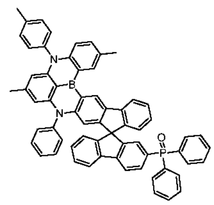

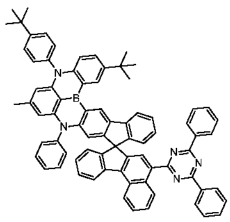 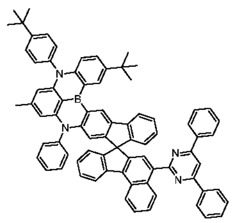 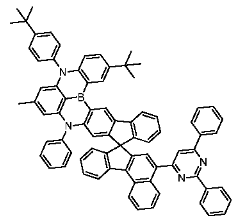 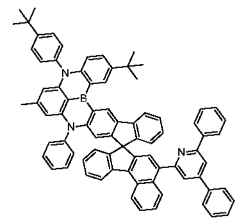

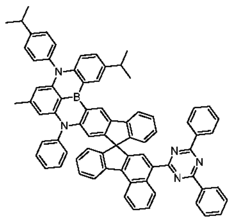 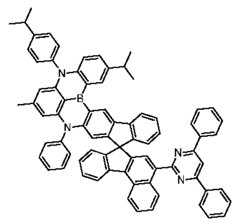 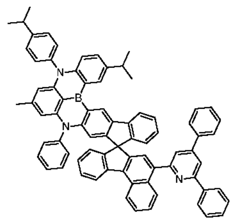 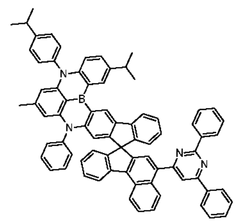

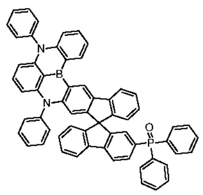 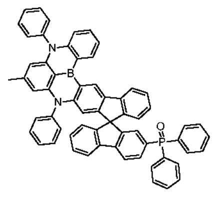 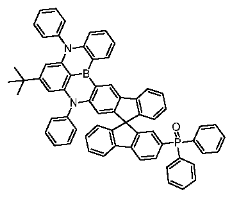 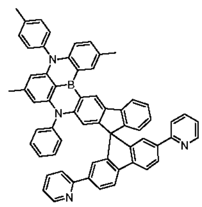

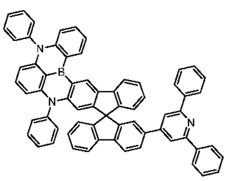 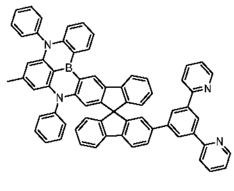 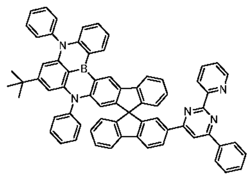 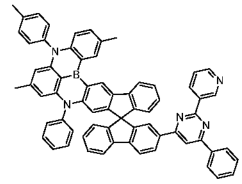

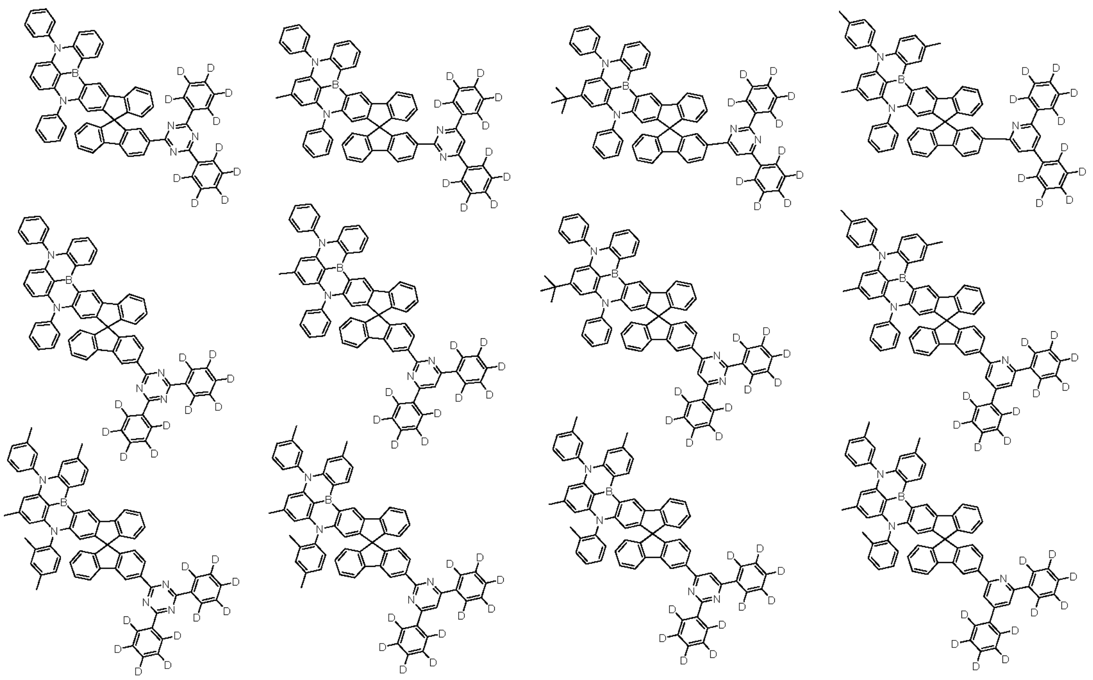

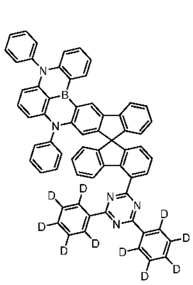

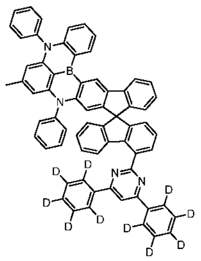

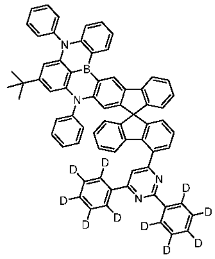

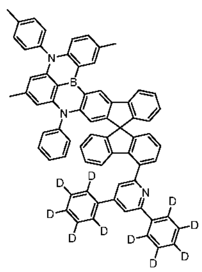

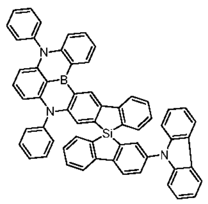

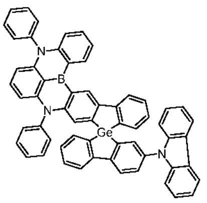

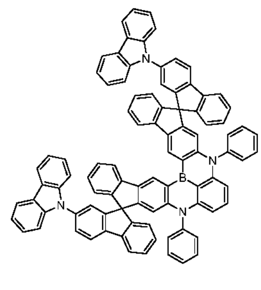

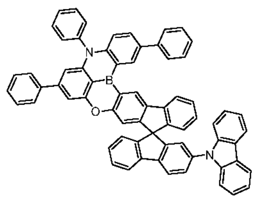

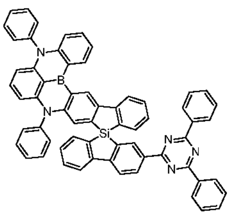

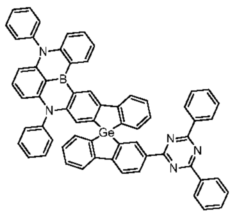

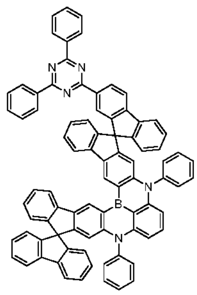

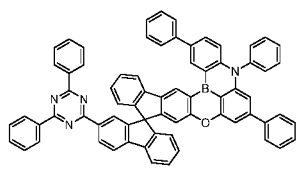

The organic light emitting diode may include the multifunctional compounds in an amount equal to or higher than the ordinary dopant content level. This means that the content of the emitting moieties can be equal to or higher than the dopant content level. For example, in order to increase the exciplex forming ratio between the exciplex forming

moieties of the multifunctional compounds and the second exciplex forming compounds, the content of the multifunctional compounds may be equal to or higher than the ordinary dopant content level. Even so, the exciplex forming moieties of the multifunctional compounds still can effectively prevent the concentration quenching phenomenon caused by the interaction between the emitting moieties in this case. Accordingly, even if the doping amount of the multifunctional compounds increases, there are high chances that efficiency and color may not be greatly affected. The ratio of the multifunctional compound in the emission layer may be, for example, in the range of 1 to 50 mol% of all materials constituting the emission layer, or more depending on the purpose.

In one embodiment, the multifunctional compound may be used as the exciplex forming compound that forms an exciplex with the exciplex-forming moiety of the multifunctional compound.

Specifically, the first multifunctional compound may be the multifunctional compound in which the exciplex forming moiety is an electron donor moiety with the emitting moiety bonded thereto so as to form the multifunctional compound, and the second multifunctional compound may the multifunctional compound in which the exciplex forming moiety is an electron acceptor moiety with the emitting moiety bonded thereto so as to form the multifunctional compound. Even in the emission layer composed of the first multifunctional compound and the second multifunctional compound only, an exciplex may be formed between each of the electron acceptor moiety and the electron donor moiety, and the energy may be transferred to the emitting moieties. In this case, the aforementioned multifunctional compound may become the first multifunctional compound, and the aforementioned exciplex forming compound may become the second multifunctional compound. At this time, depending on the mixing ratio of the first multifunctional compound and the second multifunctional compound, either one may exceed 50 mol% or more. For example, the emission layer may include more than 50 mol% of the first multifunctional compound, and this case becomes an example of the case where the content of the multifunctional compound exceeds 50 mol% as described above.

In order to further increase the light emitting efficiency of the emission layer, the emission layer may further include phosphorescent material.

In one embodiment, the emission layer may further include a phosphorescent material including Pt or Ir.

The compounds represented by the following structural formulae are exemplified as organic metal complexes commonly used as phosphorescent materials. In the formulae below, R may be an alkyl having 1 to 20 carbon atoms, an aryl having 6 to 30 carbon atoms, and the like.

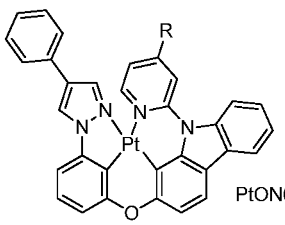
PtON6-tBu

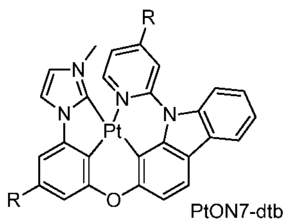
PtON7-dtb

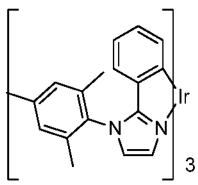

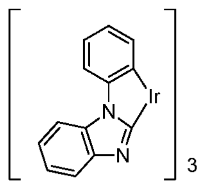

In order to further increase light emitting efficiency of the emission layer, the emission layer may further include a thermally activated delayed fluorescent material.

In one embodiment, the emission layer may further include a thermally activated delayed fluorescent material having the difference in the energy between a singlet and a triplet of 0.3 eV or more.

The compounds represented by the following structural formulae are shown as examples of commonly used thermally activated delayed fluorescent materials. Ar may be an alkyl having 1 to 20 carbon atoms or an aryl having 6 to 30 carbon atoms.

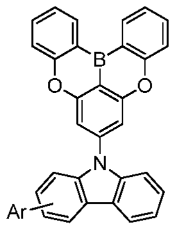

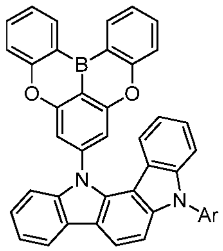

The organic light emitting diode may include, as the organic layer, one selected from the group consisting of a hole injection layer, a hole transport layer, an electron blocking layer, a hole blocking layer, an electron transport layer, an electron injection layer and combinations thereof.

In one embodiment, the organic light emitting diode includes an anode, a hole injection layer (HIL), a hole transport layer (HTL), an emission layer (EML), an electron transport layer (ETL) and a cathode sequentially.

The organic light emitting diode may be a tandem type organic light emitting diode including a plurality of organic light emitting units. One organic light emitting unit includes an emission layer and may further include at least one organic layer. The organic layer may include one selected from the group consisting of a hole injection layer, a hole transport layer, an electron blocking layer, a hole blocking layer, an electron transport layer, an electron injection layer and combinations thereof.

A plurality of the organic light emitting units may be sequentially stacked, and may include a charge generation layer (CGL) between each of the organic light emitting unit. The charge generation layer is positioned between the organic light emitting units, so that charges can be smoothly distributed to the emission layer of each organic light emitting unit.

In the tandem type organic light emitting diode, at least one organic light emitting unit may include an emission layer including the multifunctional compound, and the organic light emitting unit may or may not include an organic layer(s) adjacent to one or both surfaces of the emission layer,

the emission layer including the multifunctional compound or the organic layer(s) includes an exciplex forming compound,
the multifunctional compound includes an exciplex forming moiety and an emitting moiety;
the exciplex forming moiety forms an exciplex with the exciplex forming compound; and
the emitting moiety emits light by receiving the excited energy of the exciplex, which is transferred to the emitting moiety.

In the tandem type organic light emitting diode, the detailed descriptions of the multifunctional compound, the exciplex forming compound, and the like are the same as described above.

Examples and comparative examples of the present disclosure are described below. The following examples are only examples of the present disclosure, but the present disclosure is not limited to the following examples.

## EXAMPLES

SYNTHESIS EXAMPLE 1

Compound 3 was synthesized as the multifunctional compound.

<Compound 1>

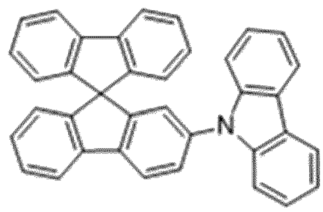

<Compound 2>

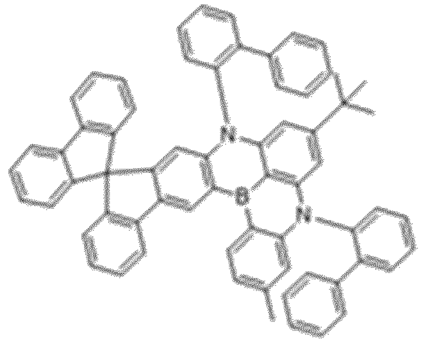

<Compound 3>

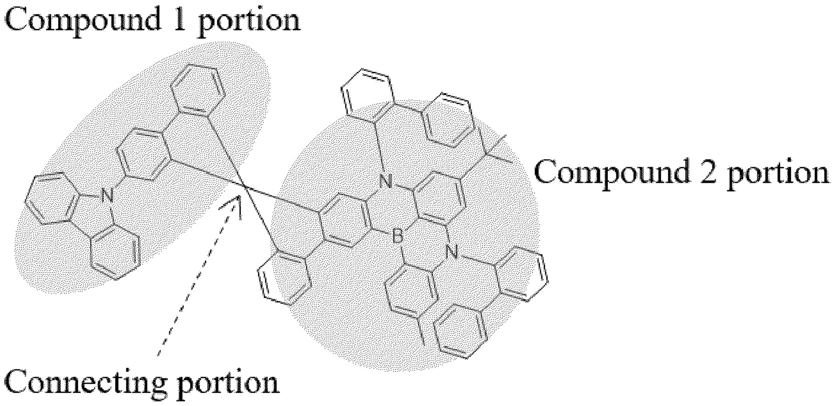


Compound 1 was the first exciplex forming compound as mentioned above, and Compound 2 of the emitting compound as mentioned above was chemically bonded thereto forming a spiro structure, and as a result, Compound 3 was synthesized as the multifunctional compound. In the structural formula of Compound 3, "Compound 1 portion" corresponds to the exciplex forming moiety derived from Compound 1 and "Compound 2 portion" corresponds to the emitting moiety derived from Compound 2. The multifunctional compound of Compound 3 has a structure in which the exciplex forming moiety and the emitting moiety are spiro bonded through carbon.

(Synthesis of Compound 1)

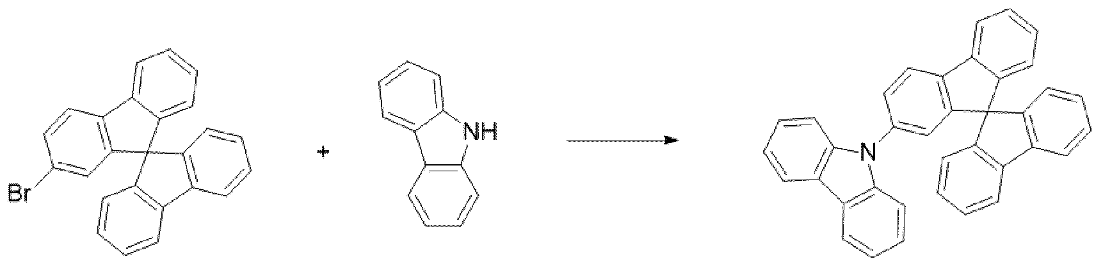

Compound 1-1 Compound 1-2 Compound 1

In a round bottom flask reactor, 3.95 g (10.0 mmol) of Compound 1-1, 2.01 g (0.012 mol) of Compound 1-2, 0.275 g (0.3 mmol) of tris(dibenzylideneacetone)dipaladium(0), and 2.88 g (0.03 mol) of sodium tertiary butoxide, 0.606 g (0.3 mmol) of tritertiary butyl phosphine and 60 ml of toluene were added, followed by refluxing and stirring for 2 hours.

After completion of the reaction, the mixture was cooled to room temperature. The reaction solution was extracted with dichloromethane and water. The organic layer was separated, anhydride treated with magnesium sulfate, and then concentrated under reduced pressure. The material was separated and purified by column chromatography and then recrystallized using dichloromethane and acetone to obtain (3.1 g, 36%).

After cooling the reaction solution to room temperature, cooled water was added, and the organic layer was extracted using ethyl acetate. After drying the solvent of the extracted organic layer with $MgSO_4$, it was filtered. After concentrating the filtrate under reduced pressure, it was purified using a silica gel column chromatography (DCM/Hexane) method.

Then, recrystallization and purification were performed using a DCM/Acetone mixed solvent to obtain 3.2 g of Compound 1-1 in a 60% yield.

MS (MALDI-TOF) m/z: 481[M]+

(Synthesis of Compound 2)

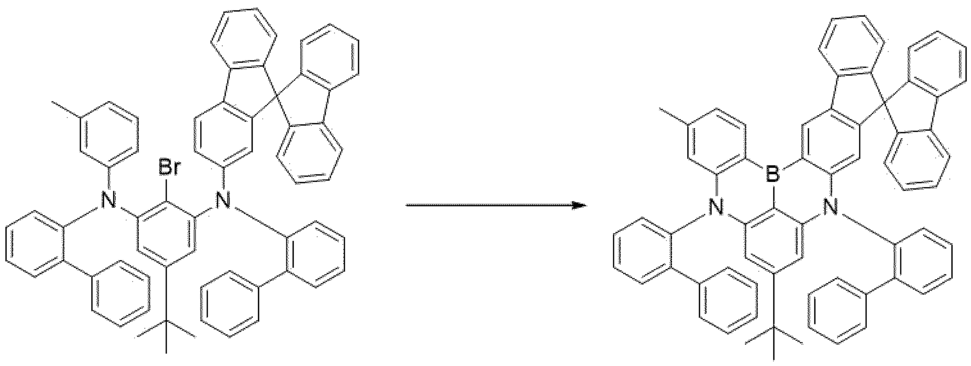

Compound 2-1 Compound 2

9.52 g (10.0 mmol) of the starting material 2-1 was dissolved in tertiary butylbenzene (32 ml), and then, cooled to 0 °C. Under a nitrogen atmosphere, 8.0 mL of 2.5M n-butyllithium solution (in hexane) (20.0 mmol) was added, followed by stirring at room temperature for 3 hours.

Then, the reactants were cooled to 0° C. again, and subsequently 1.90 mL of boron tribromide (20.0 mmol) was added thereto, followed by stirring at room temperature for 0.5 hour. The reactants were cooled to 0°C again, and 3.51 mL of N,N-diisopropylethylamine (20.0mmol) was added thereto, followed by stirring at 60-70°C for 2 hours.

The reaction solution was cooled to room temperature, and the organic layer was extracted with ethyl acetate. After drying the solvent of the extracted organic layer with $MgSO_4$, it was filtered. After concentrating the filtrate under reduced pressure, it was purified using a silica gel column chromatography (DCM/Hexane) method.

Then, recrystallization and purification were performed using a DCM/acetone mixed solvent to obtain 1.05 g of Compound 2 in a yield of 12%.

MS (MALDI-TOF) m/z: 880[M]+

NMR: $\delta_H$ (400 MHz; $CDCL_3$; $Me_4Si$) 9.13(1 H, s), 8.86-8.83 (1 H, m), 7.92-7.90 (1 H, m), 7.78 (1 H, d, J 8.0), 7.73-7.64 (4 H, m), 7.44-7.27 (8 H, m), 7.17-6.86 (11 H, m), 6.80-6.57(5 H, m), 6.49(1 H, d, J 4.0).6.37(1 H, d, J 8.0), 6.12(2 H, t), 5.89(1 H, d, J 8.0), 2.36(3 H, s), 0.96(9 H, s)

(Synthesis of Compound 3)

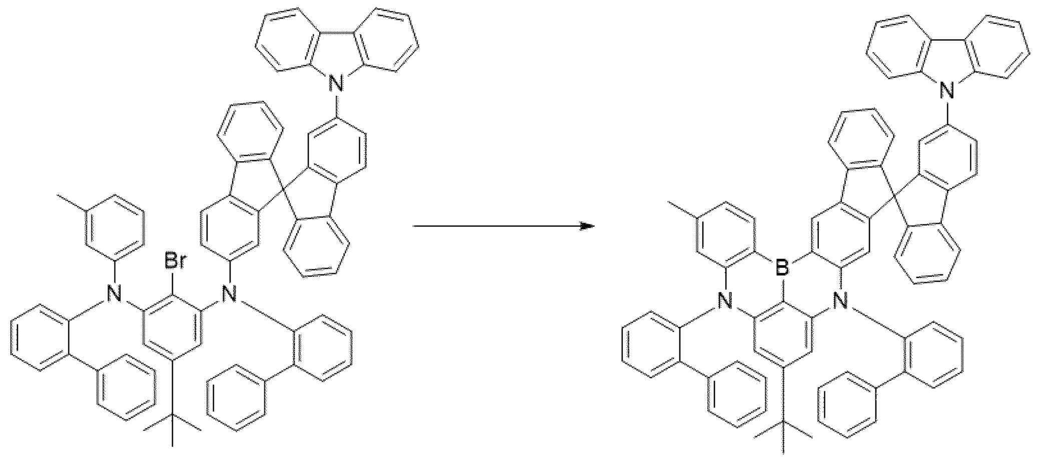

Compound 3-1 Compound 3

The same method was performed as in (Synthesis of Compound 2), except that Compound 3-1 was used instead of Compound 2-1 in the same molar ratio.

Thereafter, 1.0 g of Compound 3 was obtained in a 9% yield.

MS (MALDI-TOF) m/z: 1046[M]+

NMR: $\delta_H$ (400 MHz; $CDCL_3$; $Me_4Si$) 9.13(1 H, s), 8.86-8.83 (1 H, m), 7.92-7.90 (1 H, m), 7.78 (1 H, d, J 8.0), 7.73-7.64 (6 H, m), 7.44-7.27 (11 H, m), 7.17-6.86 (13 H, m), 6.80-6.57(5 H, m), 6.49(1 H, d, J 4.0).6.37(1 H, d, J 8.0), 6.12(2 H, t), 5.89(1 H, d, J 8.0), 2.36(3 H, s), 0.96(9 H, s)

Evaluation Example 1

Energy transfer between the moieties in Compound 3 was confirmed by comparing the energy transfer phenomena of Compounds 1, 2 and 3. Fig. 3 shows absorption and emission spectra measured for Compounds 1, 2 and 3. For the measurement sample, each material was dissolved in a toluene solution to have a 2 micromolar concentration, and was measured using SHIMADZU RF5301PC, SHIMADZU UV 2550.

Comparing the absorption spectra of Compound 2 and Compound 3, it can be confirmed that the absorbance in the 300-350 nm region of Compound 3 was increased, which is due to the absorption of the exciplex forming moiety of Compound 3. Absorbance at 330 nm in Compound 3 was increased by about 2 times compared to Compound 2. A phenomenon, in which energy is transferred from the exciplex forming moiety to the emitting moiety in Compound 3 of a multifunctional compound, can be confirmed through the emission spectra of the two materials. When Compound 2 and Compound 3 were excited at 330 nm, the emission intensity of the emitting moiety of Compound 3 was increased by about 1.8 times compared to that of Compound 2, and the emission spectrum of the exciplex forming moiety disappeared. Thus, it can be clearly confirmed that the energy transfer phenomenon described in FIG. 1 is implemented.

According to Evaluation Example 1, it was confirmed that energy transfer occurs efficiently when the distance between the energy donor (the first exciplex forming compound) and the energy acceptor (the emitting compound) is very close (i.e., through the chemical bond).

Example 1-4 and Comparative Example 1-4

The following compounds were prepared.

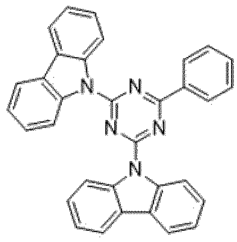

Compound A

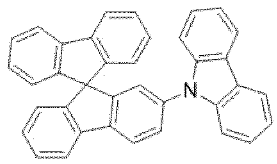

Compound 1

The compound A is capable of forming an exciplex with compound 1.

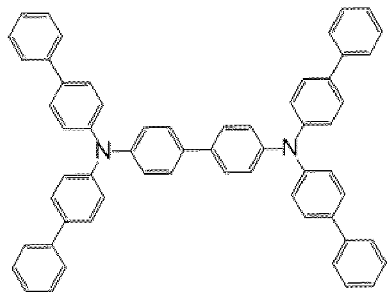

Compound B

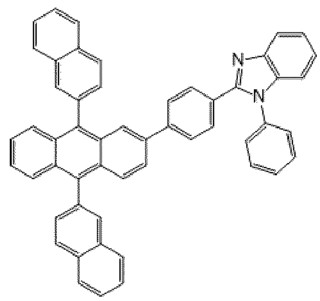

Compound C

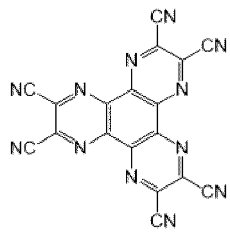

HATCN

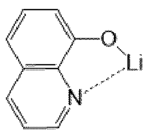

LiQ

<Preparation of organic light emitting diode>

The ITO surface was treated with UV ozone for 3 minutes at atmospheric pressure.

The device was processed in a $10^{-7}$ torr vacuum chamber, following the sequences below.

Comparative Example 1

HATCN as a hole injection material was deposited to a thickness of 50 Å.

Compound B as a hole transport material was deposited to a thickness of 1000 Å.

For an electron blocking layer, Compound 1 was deposited to a thickness of 50 Å.

For an emission layer, Compound A was deposited to a thickness of 250 Å.

For an electron transport layer, compound C and LiQ were deposited to a thickness of 300 Å at a ratio of 1:1.

For an electron injection layer, a compound LiQ was deposited to a thickness of 10 Å.

For an electrode, Al was deposited to a thickness of 500 Å.

Comparative Example 2

An organic light emitting diode was manufactured in the same manner as in Comparative Example 1 except that the electron blocking layer was doped with 5 mol% of Compound 2 and the emission layer was doped with 5 mol% of Compound 2.

Comparative Example 3

An organic light emitting diode was manufactured in the same manner as in Comparative Example 1, except that the electron blocking layer was doped with 5 mol% of Compound 2 and the emission layer was doped with 10 mol% of Compound 2.

Comparative Example 4

An organic light emitting diode was manufactured in the same manner as in Comparative Example 1 except that the electron blocking layer was doped with 5 mol% of Compound 2 and the emission layer was doped with 15 mol% of Compound 2.

Example 1

An organic light emitting diode was manufactured in the same manner as in Comparative Example 1, except that the electron blocking layer was doped with 5 mol% of Compound 3 and the emission layer was doped with 5 mol% of Compound 3.

Example 2

An organic light emitting diode was manufactured in the same manner as in Comparative Example 1, except that the electron blocking layer was doped with 5 mol% of Compound 3 and the emission layer was doped with 10 mol% of Compound 3.

Example 3

An organic light emitting diode was manufactured in the same manner as in Comparative Example 1 except that the electron blocking layer was doped with 5 mol% of Compound 3 and the emission layer was doped with 15 mol% of Compound 1.

Example 4

An organic light emitting diode was manufactured in the same manner as in Comparative Example 1 except that the electron blocking layer was doped with 5 mol% of Compound 3 and the emission layer was doped with 20 mol% of Compound 1.

Evaluation Example 2

FIG. 4 is an emission spectrum showing that an exciplex was not quiet formed between Compound A and Compound 2a, and that an exciplex was formed between Compound A and Compound 1. At this time, Compound A and Compound 2a; and Compound A and Compound 1; were mixed at a molar ratio of 6:4 and dissolved in a toluene solution to prepare a film by casting, and an emission spectrum was obtained by excitation with 330 nm light. It can be seen that no new wavelength peaks were observed between Compound A and Compound 2a, indicating that no exciplex was formed. In the mixed film of Compound A and Compound 1, the peaks of Compound 1 disappeared and a new peak in the 490 nm region were observed, indicating that an exciplex was formed.

Since the below marked part of Compound 2 has the structure of the Compound 2a portion, Compound 2 does not form an exciplex with compound A.

Compound 2 Compound 3

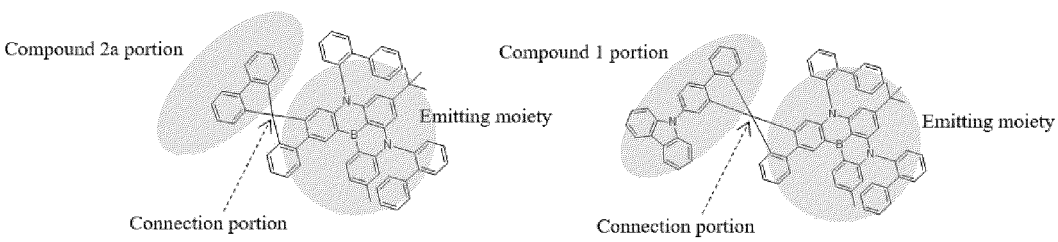


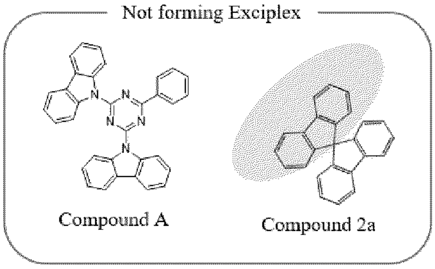


Compound A Compound 2a

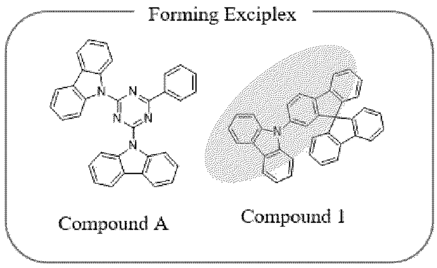


Compound A Compound 1

Meanwhile, Compound 3 forms an exciplex with compound A as the compound 2a portion in compound 2 is replaced with a moiety derived from Compound 1 (Compound 1 portion, corresponding to an exciplex forming moiety).

In Comparative Example 2-4 where devices were manufactured using Compound 2, efficiency was not increased because exciplexes were not formed, and Examples 1-4 where devices were manufactured using Compound 3, efficiency was increased because exciplexes were formed. This could be confirmed from the following results of the evaluation for the devices.

Evaluation Example 3

The organic light emitting diodes manufactured in Examples 1 to 4 and Comparative Examples 1 to 4 were evaluated for device characteristics at room temperature using a current source (KEITHLEY) and a photometer (PR 650). Table 1 below shows driving voltage (V), maximum EQE (external quantum efficiency), and CIE color coordinate measurement results measured for the organic light emitting diodes of Examples 1 to 4 and Comparative Examples 1 to 4.

**TABLE 1**

| Index | Dopant | Doping conc. (mol%) | Voltage (V) | Maximum EQE (%) | CIE X | CIE Y |
|---|---|---|---|---|---|---|
| Comparative Example 1 | - | - | 3.3 | 0.93 | 0.184 | 0..210 |
| Comparative Example 2 | Compound 2 | 5 | 3.3 | 7.29 | 0.130 | 0.128 |
| Comparative Example 3 | Compound 2 | 10 | 3.0 | 9.81 | 0.143 | 0.156 |
| Comparative Example 4 | Compound 2 | 15 | 3.1 | 5.32 | 0.146 | 0.225 |
| Example 1 | Compound 3 | 5 | 3.0 | 7.88 | 0.142 | 0.127 |
| Example 2 | Compound 3 | 10 | 2.8 | 10.43 | 0.137 | 0.154 |
| Example 3 | Compound 3 | 15 | 2.7 | 14.92 | 0.141 | 0.180 |
| Example 4 | Compound 3 | 20 | 2.6 | 16.67 | 0.140 | 0.189 |

As can be seen from Table 1, it can be confirmed that the organic light emitting diodes using the multifunctional compounds of Examples 1 to 4 show high quantum efficiency and color stability characteristics with increase of doping concentration.

As described above, it is obvious that the present disclosure can be applied not only to organic light emitting diodes manufactured by a deposition process but also to organic light emitting diodes manufactured by a solution process, as in the embodiments.

While the present disclosure has been described with reference to embodiments as described above, the embodiments set forth herein are not intended to limit the present disclosure, and it is obvious that various modifications

can be made by those skilled in the art within the scope of the technical spirit of the present disclosure. In addition, even if not explicitly described about functioning effects according to the configurations of the present disclosure in the foregoing detailed description of embodiments, it is apparent that predictable effects of the corresponding configurations should also be acknowledged.

## Claims

1. An organic light emitting diode comprising a first electrode, a second electrode and an emission layer interposed between the first electrode and the second electrode,

   wherein the organic light emitting diode includes or does not include an organic layer(s) adjacent to one or both surfaces of the emission layer;
   the emission layer includes a multifunctional compound;
   the emission layer or the organic layer(s) includes an exciplex forming compound;
   the multifunctional compound includes an exciplex forming moiety and an emitting moiety;
   the exciplex forming moiety forms an exciplex with the exciplex forming compound; and
   the emitting moiety emits light by receiving excited energy of the exciplex, which is transferred to the emitting moiety.

2. The organic light emitting diode according to claim 1, wherein the exciplex forming moiety is derived from a compound that is capable of forming an exciplex with the exciplex forming compound.

3. The organic light emitting diode according to claim 1, wherein Condition 1 or Condition 2 below is satisfied, in which a HOMO energy of the exciplex forming moiety is $E(1)_{HOMO}$, a LUMO energy of the exciplex forming moiety is $E(1)_{LUMO}$, a HOMO energy of the exciplex forming compound is $E(2)_{HOMO}$, and a LUMO energy of the exciplex forming compound is $E(2)_{LUMO}$,

   <Condition 1>

   $$|E(1)_{HOMO}| \leq |E(2)_{HOMO}|$$

   $$|E(1)_{LUMO}| \leq |E(2)_{LUMO}|$$

   and

   <Condition 2>

   $$|E(1)_{HOMO}| \geq |E(2)_{HOMO}|$$

   $$|E(1)_{LUMO}| \geq |E(2)_{LUMO}|$$

   and
   ; and Condition 3 or Condition 4 below is satisfied, in which exciplex emission energy at a maximum emission wavelength is E(ex) when the exciplex forming moiety and the exciplex forming compound form the exciplex.

   <Condition 3>

   $$|E(1)_{HOMO}| - |E(2)_{LUMO}| \geq E(ex)$$

<Condition 4>

$$\left| E(2)_{HOMO} \right| - \left| E(1)_{LUMO} \right| \geq E(ex)$$

4. The organic light emitting diode according to claim 1, wherein the emitting moiety is derived from an emitting material.

5. The organic light emitting diode according to claim 1, wherein the emitting moiety has a conjugated structure with a quantum efficiency of 50% or more in the visible light wavelength range of 400 nm to 700 nm.

6. The organic light emitting diode according to claim 1, the emitting moiety has a conjugated structure with a quantum efficiency of 10% or more in the near-infrared wavelength range of 700 nm to 2200 nm.

7. The organic light emitting diode according to claim 1, wherein light emitting mechanism of the emitting moiety includes fluorescence emitting light from a singlet, phosphorescence emitting light from a triplet, and thermally activated delayed fluorescence emitting light when energy is transferred from a triplet to a singlet.

8. The organic light emitting diode according to claim 1, wherein band gap energy of the exciplex forming moiety is greater than band gap energy of the emitting moiety.

9. The organic light emitting diode according to claim 1, wherein the exciplex forming moiety and the emitting moiety in the multifunctional compound are linked by a chemical bond.

10. The organic light emitting diode according to claim 1, wherein the multifunctional compound is substituted with deuterium.

11. The organic light emitting diode according to claim 9, wherein the chemical bond is a single bond, a double bond, a triple bond or a coordination bond.

12. The organic light emitting diode according to claim 9, wherein the chemical bond is connection through an arylene having 6 to 20 carbon atoms, a carbon atom, an oxygen atom, a nitrogen atom, a silicon atom, a Ge atom, an S atom, or a P atom.

13. The organic light emitting diode according to claim 9, wherein the exciplex forming moiety and the emitting moiety are connected in a spiro structure using a medium of carbon, silicon or Ge.

14. The organic light emitting diode according to claim 9, wherein the emitting moiety is derived from an emitting compound, and
in the multifunctional compound, the exciplex forming moiety connected by the chemical bond does not change a band gap energy of the emitting moiety by 0.2 eV or more compared to a band gap energy of the emitting compound prior to formation of the chemical bond.

15. The organic light emitting diode according to claim 1, wherein the exciplex forming moiety has a band gap energy of 1 eV to 4.7 eV, and the emitting moiety has a band gap energy of 0.5 eV to 3.5 eV; and
a difference in the band gap energies between the exciplex forming moiety and the emitting moiety is 2 eV or less.

16. The organic light emitting diode according to claim 1, wherein a difference in HOMO energy levels between the exciplex forming moiety and the emitting moiety is 1.9 eV or less, and
an energy level difference between a LUMO energy of the exciplex forming moiety and a LUMO energy of the emitting moiety is 1.9 eV or less.

17. The organic light emitting diode according to claim 1, wherein the exciplex forming moiety is derived from an electron donor material represented by Formula 1 below, or derived from an electron acceptor material represented by any of the structures represented by Formula 2 below.

< Formula 1>

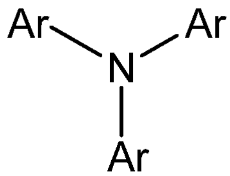

In Formula 1,
Ar is, each independently, a substituted or unsubstituted aryl having 6 to 30 carbon atoms, a substituted or unsubstituted heteroaryl having 5 to 30 carbon atoms, or a substituted or unsubstituted alkyl having 1 to 20 carbon atoms and Ar may be connected to form a fused ring having 12 to 30 carbon atoms, and
at least one hydrogen atom in Formula 1 is unsubstituted or substituted with deuterium.

< Formula 2>

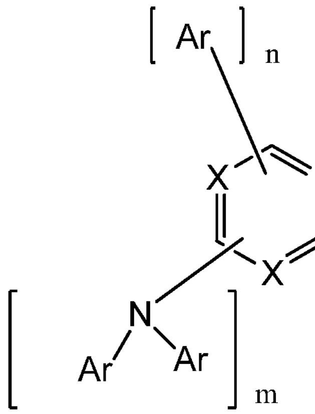

In Formula 2,
X is nitrogen or carbon,
n and m are integers from 0 to 6, provided that when X is nitrogen, n+m is an integer from 1 to 3, and when X is carbon, n+m is an integer from 1 to 6;
Ar is each independently substituted or unsubstituted aryl having 6 to 30 carbon atoms, substituted or unsubstituted heteroaryl having 5 to 30 carbon atoms, substituted or unsubstituted arylsilyl having 6 to 30 carbon atoms, substituted or unsubstituted aryloxy having 6 to 30 carbon atoms, substituted or unsubstituted alkylsilyl having 1 to 20 carbon atoms, substituted or unsubstituted alkyl having 1 to 20 carbon atoms, substituted or unsubstituted aryl group having 6 to 30 carbon atoms including phosphine or phosphine oxide, and the two of Ar may be connected to form a fused ring having 12 to 30 carbon atoms, and
at least one hydrogen atom in Formula 2 is unsubstituted or substituted with deuterium.

**18.** The organic light emitting diode according to claim 1, wherein the exciplex forming moiety is derived from an organic compound or an organometallic complex.

**19.** The organic light emitting diode according to claim 1, wherein the emitting moiety has a conjugated structure including boron.

**20.** The organic light emitting diode according to claim 1, wherein the emitting moiety contains a metal.

**21.** The organic light emitting diode according to claim 1, wherein the emission layer further includes a phosphorescent material containing Ir or Pt.

**22.** The organic light emitting diode according to claim 1, wherein the emission layer further includes a thermally activated delayed fluorescent material having a singlet and triplet energy difference of 0.3 eV or more.

**23.** The organic light emitting diode according to claim 1, wherein the organic light emitting diode is a tandem type

organic light emitting diode including a plurality of organic light emitting units, and at least one of the plurality of organic light emitting units includes the emission layer.

[Fig. 1]

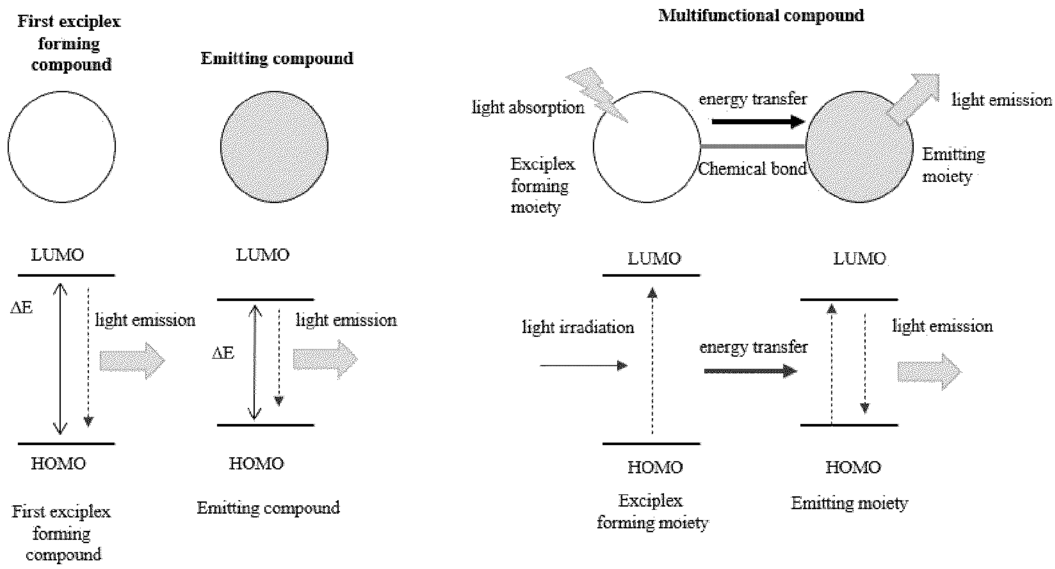
First exciplex forming compound
Emitting compound
LUMO
ΔE
light emission
LUMO
ΔE
light emission
HOMO
HOMO
First exciplex forming compound
Emitting compound
Multifunctional compound
light absorption
energy transfer
light emission
Exciplex forming moiety
Chemical bond
Emitting moiety
LUMO
LUMO
light irradiation
energy transfer
light emission
HOMO
HOMO
Exciplex forming moiety
Emitting moiety

[Fig. 2]

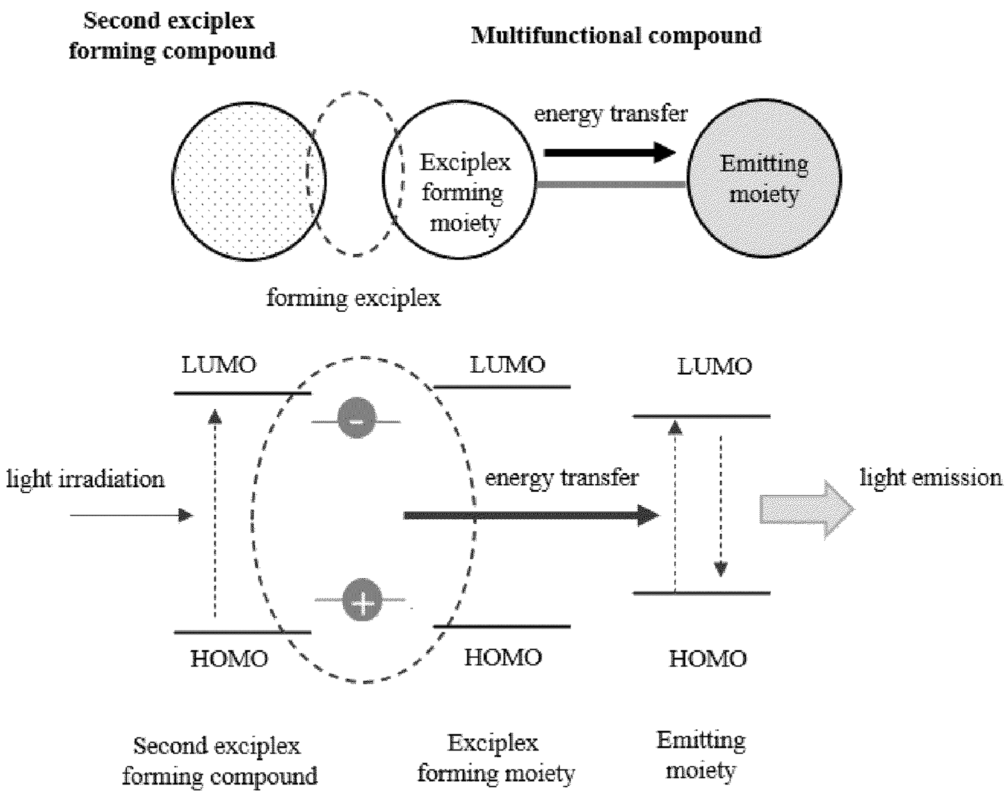
Second exciplex forming compound
Multifunctional compound
energy transfer
Exciplex forming moiety
Emitting moiety
forming exciplex
LUMO
LUMO
LUMO
light irradiation
energy transfer
light emission
HOMO
HOMO
HOMO
Second exciplex forming compound
Exciplex forming moiety
Emitting moiety

[Fig. 3]

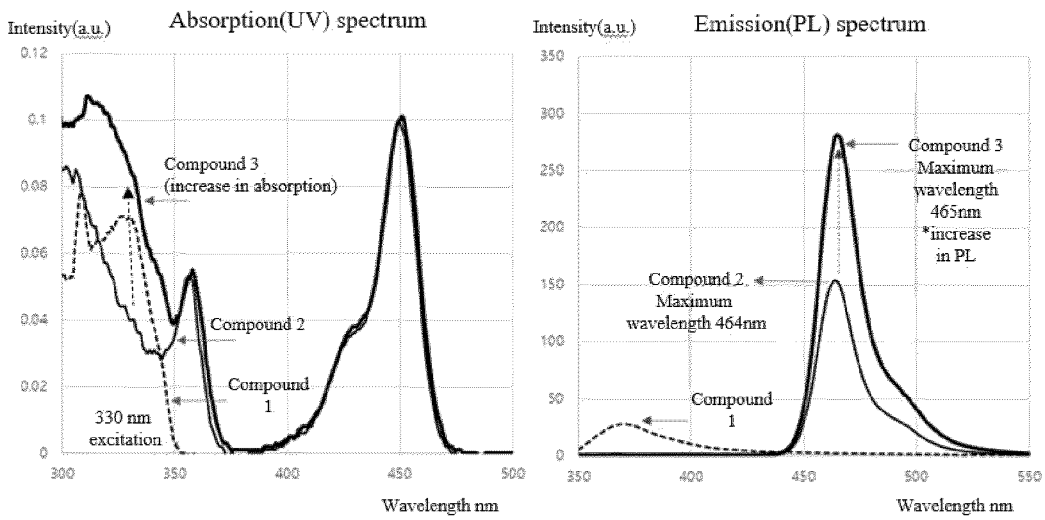


[Fig. 4]

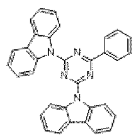

Compound A

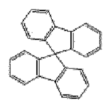

Compound 2a

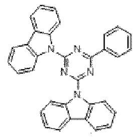

Compound A

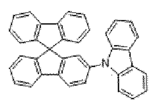

Compound 1

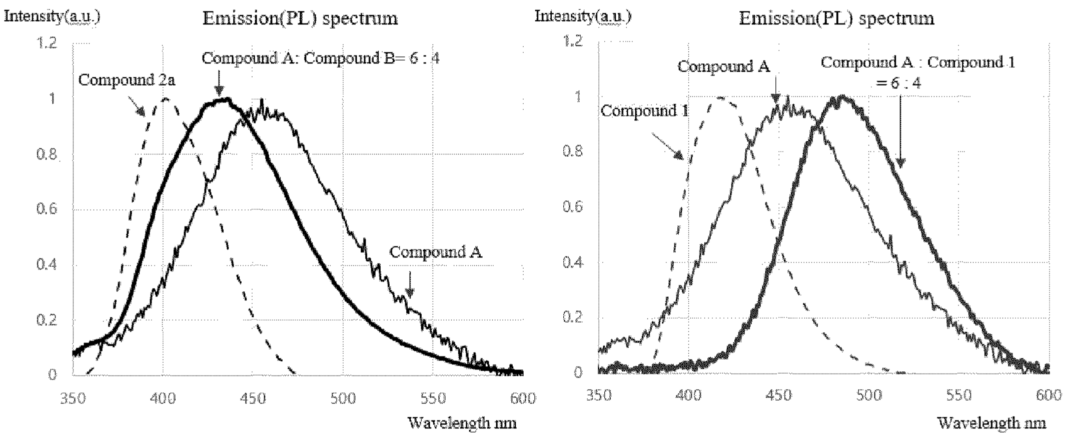

## INTERNATIONAL SEARCH REPORT

International application No.
**PCT/KR2022/007113**

**A. CLASSIFICATION OF SUBJECT MATTER**

**H01L 51/50**(2006.01)i; **H01L 51/00**(2006.01)i; **C09K 11/06**(2006.01)i

According to International Patent Classification (IPC) or to both national classification and IPC

**B. FIELDS SEARCHED**

Minimum documentation searched (classification system followed by classification symbols)

H01L 51/50(2006.01); C07C 211/61(2006.01); C07C 217/94(2006.01); C07D 209/86(2006.01); C07D 239/48(2006.01); C07D 403/14(2006.01); C07F 1/08(2006.01); C07F 1/10(2006.01); C07F 5/02(2006.01); C09K 11/06(2006.01); F21Y 105/00(2006.01); H01L 51/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 유기발광소자(OLED, organic light emitting device, organic electroluminescence), 발광층(light emitting layer), 들뜬 복합체(exciplex), 전자주개(electron donor), 전자받개(electron acceptor)

**C. DOCUMENTS CONSIDERED TO BE RELEVANT**

| Category* | Citation of document, with indication, where appropriate, of the relevant passages | Relevant to claim No. |
|---|---|---|
| A | KR 10-2010-0015572 A (NIPPON STEEL CHEMICAL CO., LTD.) 12 February 2010 (2010-02-12)<br>See claims 1-10; and paragraphs [0081], [0082], [0113]-[0116] and [0121]. | 1-23 |
| A | KR 10-2017-0121057 A (SEMICONDUCTOR ENERGY LABORATORY CO., LTD.) 01 November 2017 (2017-11-01)<br>See claims 1-21. | 1-23 |
| A | KR 10-2021-0067007 A (SAMSUNG DISPLAY CO., LTD.) 08 June 2021 (2021-06-08)<br>See claims 1-20. | 1-23 |
| A | KR 10-2016-0026717 A (SEMICONDUCTOR ENERGY LABORATORY CO., LTD.) 09 March 2016 (2016-03-09)<br>See claims 1-32. | 1-23 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 August 2022** | **19 August 2022** |

Name and mailing address of the ISA/KR
**Korean Intellectual Property Office**
**Government Complex-Daejeon Building 4, 189 Cheongsa-ro, Seo-gu, Daejeon 35208**
Facsimile No. **+82-42-481-8578**

Authorized officer

Telephone No.

Form PCT/ISA/210 (second sheet) (July 2019)

INTERNATIONAL SEARCH REPORT

International application No. PCT/KR2022/007113

C. DOCUMENTS CONSIDERED TO BE RELEVANT

| Category* | Citation of document, with indication, where appropriate, of the relevant passages | Relevant to claim No. |
|---|---|---|
| A | KR 10-2019-0051867 A (LG CHEM, LTD. et al.) 15 May 2019 (2019-05-15) See claims 1-16. | 1-23 |
| A | CN 112552190 A (LODIN CO., LTD.) 26 March 2021 (2021-03-26) See claims 1-10. | 1-23 |
| A | KR 10-2015-0066957 A (SAMSUNG DISPLAY CO., LTD. et al.) 17 June 2015 (2015-06-17) See entire document. | 1-23 |
| A | KR 10-2018-0082464 A (GUANGDONG AGLAIA OPTOELECTRONIC MATERIALS CO., LTD.) 18 July 2018 (2018-07-18) See entire document. | 1-23 |

Form PCT/ISA/210 (second sheet) (July 2019)

**INTERNATIONAL SEARCH REPORT**
**Information on patent family members**

International application No.
**PCT/KR2022/007113**

| Patent document cited in search report | | | Publication date (day/month/year) | Patent family member(s) | | | Publication date (day/month/year) |
|---|---|---|---|---|---|---|---|
| KR | 10-2010-0015572 | A | 12 February 2010 | CN | 101641337 | A | 03 February 2010 |
| | | | | EP | 2141152 | A1 | 06 January 2010 |
| | | | | EP | 2141152 | B1 | 05 May 2021 |
| | | | | JP | 5209604 | B2 | 12 June 2013 |
| | | | | KR | 10-1505152 | B1 | 23 March 2015 |
| | | | | TW | 200907016 | A | 16 February 2009 |
| | | | | US | 2010-0127616 | A1 | 27 May 2010 |
| | | | | WO | 2008-117826 | A1 | 02 October 2008 |
| KR | 10-2017-0121057 | A | 01 November 2017 | CN | 107305926 | A | 31 October 2017 |
| | | | | CN | 107305926 | B | 20 April 2021 |
| | | | | CN | 112928222 | A | 08 June 2021 |
| | | | | DE | 102017206649 | A1 | 26 October 2017 |
| | | | | JP | 2017-199903 | A | 02 November 2017 |
| | | | | JP | 2022-084765 | A | 07 June 2022 |
| | | | | JP | 7044475 | B2 | 30 March 2022 |
| | | | | US | 10096658 | B2 | 09 October 2018 |
| | | | | US | 11177325 | B2 | 16 November 2021 |
| | | | | US | 2017-0309687 | A1 | 26 October 2017 |
| | | | | US | 2019-0027542 | A1 | 24 January 2019 |
| KR | 10-2021-0067007 | A | 08 June 2021 | CN | 112851713 | A | 28 May 2021 |
| | | | | JP | 2021-087013 | A | 03 June 2021 |
| | | | | US | 2021-0167301 | A1 | 03 June 2021 |
| KR | 10-2016-0026717 | A | 09 March 2016 | JP | 2016-207998 | A | 08 December 2016 |
| | | | | JP | 2020-053709 | A | 02 April 2020 |
| | | | | JP | 2021-121016 | A | 19 August 2021 |
| | | | | JP | 6862585 | B2 | 21 April 2021 |
| | | | | KR | 10-2022-0010053 | A | 25 January 2022 |
| | | | | KR | 10-2353647 | B1 | 20 January 2022 |
| | | | | US | 0714700 | B2 | 14 July 2020 |
| | | | | US | 10693095 | B2 | 23 June 2020 |
| | | | | US | 2016-0064684 | A1 | 03 March 2016 |
| | | | | US | 2018-0145273 | A1 | 24 May 2018 |
| | | | | US | 2019-0341570 | A1 | 07 November 2019 |
| | | | | US | 2021-0020859 | A1 | 21 January 2021 |
| | | | | US | 9911936 | B2 | 06 March 2018 |
| KR | 10-2019-0051867 | A | 15 May 2019 | CN | 111094302 | A | 01 May 2020 |
| | | | | KR | 10-2141284 | B1 | 05 August 2020 |
| | | | | WO | 2019-088799 | A1 | 09 May 2019 |
| CN | 112552190 | A | 26 March 2021 | | None | | |
| KR | 10-2015-0066957 | A | 17 June 2015 | KR | 10-2167047 | B1 | 19 October 2020 |
| | | | | US | 2015-0162553 | A1 | 11 June 2015 |
| | | | | US | 9741947 | B2 | 22 August 2017 |
| KR | 10-2018-0082464 | A | 18 July 2018 | CN | 106565592 | A | 19 April 2017 |
| | | | | CN | 106565592 | B | 25 June 2019 |
| | | | | KR | 10-2033126 | B1 | 16 October 2019 |
| | | | | TW | 201720810 | A | 16 June 2017 |
| | | | | TW | I623532 | B | 11 May 2018 |
| | | | | US | 0374169 | B2 | 06 August 2019 |
| | | | | US | 2018-0366655 | A1 | 20 December 2018 |

Form PCT/ISA/210 (patent family annex) (July 2019)

**INTERNATIONAL SEARCH REPORT**
**Information on patent family members**

International application No.
**PCT/KR2022/007113**

| Patent document cited in search report | Publication date (day/month/year) | Patent family member(s) | Publication date (day/month/year) |
|---|---|---|---|
| | | WO 2017-097152 A1 | 15 June 2017 |

Form PCT/ISA/210 (patent family annex) (July 2019)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6303238 B1


### Non-patent literature cited in the description


- **C. W. TANG.** *Appl. Phys. Lett,* vol. 51, 913
- **MARK E.** Thompson reported a technique for a triplet to emit light by increasing spin-orbit coupling using a heavy metal such as Pt. *Nature,* 2012, vol. 492, 234-238
- **VALEUR, B ; BERBERAN-SANTOS, M.N.** KGaA. Wiley-VCH Verlag GmbH & co, 2012